# EUROPEAN PATENT SPECIFICATION

(11) **EP 1 547 433 B1**
(45) Date of publication and mention of the grant of the patent: **25.01.2012**
(21) Application number: 04755061.1
(22) Date of filing: 10.06.2004
(51) Int. Cl.: H04R 3/00, H03F 3/217

(54) **AUDIO AMPLIFIER WITH LOCAL INTERFACE SYSTEM**
AUDIOVERSTÄRKER MIT LOKALER SCHNITTSTELLE
AMPLIFICATEUR AUDIO AVEC SYSTEME D'INTERFACE LOCALE

(30) Priority: 10.06.2003 US 477257 P
(43) Date of publication of application: 29.06.2005
(73) Proprietor: HARMAN INTERNATIONAL INDUSTRIES, INCORPORATED, Northridge California 91329 (US)
(72) Inventor: KELLOM, Marc, Granger, IN 46530 (US); MORRIS, Stephen, Granger, IN 46530 (US); SMITH, Timothy, James, Granger, IN 46530 (US); STANLEY, Gerald, R., Osceola, IN 46561 (US)
(74) Representative: Grünecker, Kinkeldey, Stockmair & Schwanhäusser
(86) International application number: PCT/US2004/018685
(87) International publication number: WO 2004/112425

(56) References cited:
- EP-A- 1 259 082
- WO-A-02/078179
- US-A- 4 638 506
- US-A1- 2002 167 354

## Description

### 1. Technical Field.

The invention generally relates to audio amplifiers and, more particularly, to a local interface system in an audio amplifier.

### 2. Related Art.

Audio amplifiers for sound systems are well known. An input audio signal representative of sound is provided to the audio amplifier. The audio amplifier increases the magnitude of the audio signal and provides the amplified audio signal as an output audio signal. The output audio signal may drive a loudspeaker or other similar device. Typically, the difference in magnitude of the audio input signal and the audio output signal is the rated output of the audio amplifier.
An example of an amplifier is disclosed in International Patent Publication No. WO 02/078179, which discloses a pulse width modulator audio power amplifier with a switch mode power converter for adjusting the duty of the switch mode power converter based on an output current. In said publication, the PWM audio amplifier may include a digital signal processor for processing an input signal and controlling the switch mode power converter to minimize distortions in an amplifier output signal.

Audio amplifiers also include an attenuator control. The attenuator control may be a rotary knob, push buttons or some other form of manual adjustment located on the audio amplifier. The attenuator control can be used to adjust the amount of attenuation applied to the input audio signal. As attenuation is increased, amplification of the input audio signal is reduced. Additional local control of the configuration of audio amplifiers is typically provided by mechanical switches located inside or at the back of the audio amplifier housing. Other indications and user interface related hardware on the audio amplifier is in the form of a numeric display, such as displaying the magnitude of the attenuation and/or indicator lights, such as a power on indication.

Remote control of audio amplifiers is also possible. Using a network and a remote terminal, a remote interface to one or more audio amplifiers may be formed. A remote interface may also be formed with other electronic equipment such as, digital signal processor (DSP) controlled devices, loudspeaker processors, mixing consoles, etc. The remote terminal may include a software application operating on a personal computer or other similar computing device. The personal computer typically includes the capability to display and manipulate operational parameters related to the individual audio amplifiers (and/or other equipment). In addition, the personal computer includes a communication port providing communication with the audio amplifiers and other equipment over the network

Each audio amplifier may include an interface port to communicate with the personal computer over the communication link. The interface port may provide input/output signal capability for the audio amplifier. Signals generated by the audio amplifier may be converted to a communication protocol and transmitted over the network to the personal computer. In addition, the interface port may translate the incoming communication protocol from the remote terminal to signals that are output by the interface port to the audio amplifier. Utilizing a user interface provided by the remote terminal, various parameters within the audio amplifiers may be adjusted. In addition, an error log and alarming capability may be provided by the software application operating on the personal computer.

In some audio systems, however, the additional expense and complexity of the remote interface system may not be warranted. In addition, such remote control is typically positioned away from the audio amplifier where visual inspection of the audio amplifier is inconvenient. Further, some setting and control related parameters are only located locally inside and/or on the audio amplifier. Such parameters are typically adjusted by manually toggling switches or making other similar manual adjustments at the audio amplifier. A user operating a remote interface system may therefore be required to frequently make trips between the remote terminal and the audio amplifiers to tune, adjust and/or maintain the sound system

Therefore, a need exists for an audio amplifier that includes a local user interface and local control capability to view and adjust parameters within the audio amplifier as well as capability to view and adjust parameters of other electrical equipment via a network.

### SUMMARY

The invention provides an audio amplifier with a local interface system and an audio processing system cooperatively operating with a power stage in an audio amplifier, as recited in claim 1. The invention further provides a method of amplifying audio signals with such an amplifier, as recited in claim 35. The local interface system is located at the amplifier and provides the capability to manipulate the control and configuration of the audio amplifier locally. In addition, the local interface system has the capability to securely limit access to only authorized users as well as provide error reporting and other diagnostic indications. Further, the local interface system is configured to provide the capability to communicate with other audio amplifiers and/or electronic devices via a packet switching network. Accordingly, parameters within network connected devices may be viewed and manipulated over the network from the local interface system.

The local interface system includes a user interface on the audio amplifier that includes visual indication and user input capability. The visual indication includes a display capable of displaying multiple lines of text and or graphics, and indicators, such as light emitting diodes (LEDs). The user input capability may also include at least one rotary encoder as well as at least one button. The functionality of the rotary encoder and the button(s) may be dynamically configured based on the image/text currently displayed in the display. Inputs from the audio amplifier as well as other devices on the network may be received by the local interface system. Outputs to other devices on the network may also be generated with the local interface system.

A user may negotiate through a plurality of menu screens using the display. Within the menu screens, the user may have the capability to configure, control and/or monitor the audio amplifier as well as other network connected devices. The local interface system includes analog and/or digital input/output capability, and a user interface controller. The user interface controller may execute instructions to drive the display based on inputs from the user as well as operational inputs provided by the audio amplifier itself.

The audio processing system is coupled with the local interface system The audio processing system is configured to provide an interface to the packet switching network for the local interface system. The local interface system may communicate with the audio processing system over an asynchronous communication link. The audio processing system and the local interface system may each receive different signals indicative of various operational parameters of the amplifier. In addition, each of the audio processing system and the local interface system may generate output signals to direct the operation of the amplifier. Inputs/outputs provided to/from one of the audio processing system and the local interface system may be communicated via the serial link line to the other system. Updates to the instructions stored in the audio processing system and the local interface system may also be performed over the packet switched network via the audio processing system.

Included in the audio processing system is an audio signal controller, a packet switching network interface and a digital signal processor. The packet switching network interface may allow communication over the packet switching network. The digital signal processor is configured to receive and process at least one audio input signal to form a plurality of audio output signals. The digital signal processor is configured to adjust a gain of the audio input signal as directed by the audio signal controller.

The audio signal controller may direct the digital signal processor based on a gain command initiated locally from the local interface system or remotely by commands received over the packet switching network. In addition, the digital signal processor may be directed by the audio signal controller to dynamically adjust the processing of the audio input signal to optimize the frequency response of the power stage. The power stage includes a switching amplifier output stage configured to receive and amplify the audio output signals to provide amplified audio output signals to a load such as one or more loudspeakers.

Other systems, methods, features and advantages of the invention will be, or will become, apparent to one with skill in the art upon examination of the following figures and detailed description. It is intended that all such additional systems, methods, features and advantages be included within this description, be within the scope of the invention, and be protected by the following claims.

### BRIEF DESCRIPTION OF THE DRAWINGS

The invention can be better understood with reference to the following drawings and description. The components in the figures are not necessarily to scale, emphasis instead being placed upon illustrating the principles of the invention. Moreover, in the figures, like reference numerals designate corresponding parts throughout the different views.
FIG. 1 is a perspective view of an example audio amplifier that includes a local interface system.
FIG. 2 is a block diagram of an example audio amplifier that includes the local interface system.
FIG. 3 is an example circuit schematic of a balanced reconstruction filter included within the audio amplifier illustrated in FIG 2.
FIG. 4 is a block diagram of an example audio amplifier that includes the local interface system.
FIG. 5 is an example circuit schematic of a portion of the local interface systems illustrated in FIGS. 2 and 4.
FIG. 6 is a flow diagram illustrating operation of the audio amplifier of FIG. 1.

### DETAILED DESCRIPTION OF THE PREFERRED EMBODIMENTS

This invention provides a local interface system for an audio amplifier. The local interface system resides within the audio amplifier, and provides local control and/or configuration capability of the audio amplifier. In addition, the local interface system may enable access and/or configuration of other network connected devices.

Control capability may involve local adjustment of audio amplifier parameters to control operation and performance. Control capability may also include the ability to effect the operation or performance of other network components that may be coupled to the audio amplifier with a packet switching network. Configuration capability provides a local interface for entering/changing/reviewing various operational settings of the audio amplifier and other network connected devices. In addition, error logs, alarm messages, diagnostics and other operationally related indications may be accessed locally at the audio amplifier. Further, the local configuration capability provides for customization, such as adding unique identifiers etc. at the audio amplifier. When the audio amplifier is connected in a packet switching network, configuration capability may also include the ability to enter, change, or review aspects of other network connected devices. In addition, it may be possible for other network connected devices to control or setup the configuration of the local interface system remotely.

As used herein, the term "packet switching network" or "packet switched network" is defined as any network based communication system that breaks a message into smaller packets for transmission and switches them to their required destination. Unlike circuit switching, which requires a constant point-to-point circuit to be established, each packet in a packet-switched network contains a destination address. Thus all packets in a single message do not have to travel the same path. They can be dynamically routed over the network as lines become available or unavailable. The destination device may reassemble the packets back into their proper sequence. The phrase "coupled with" is defined to mean directly connected to or indirectly connected through one or more intermediate components. Such intermediate components may include both hardware and software based components.

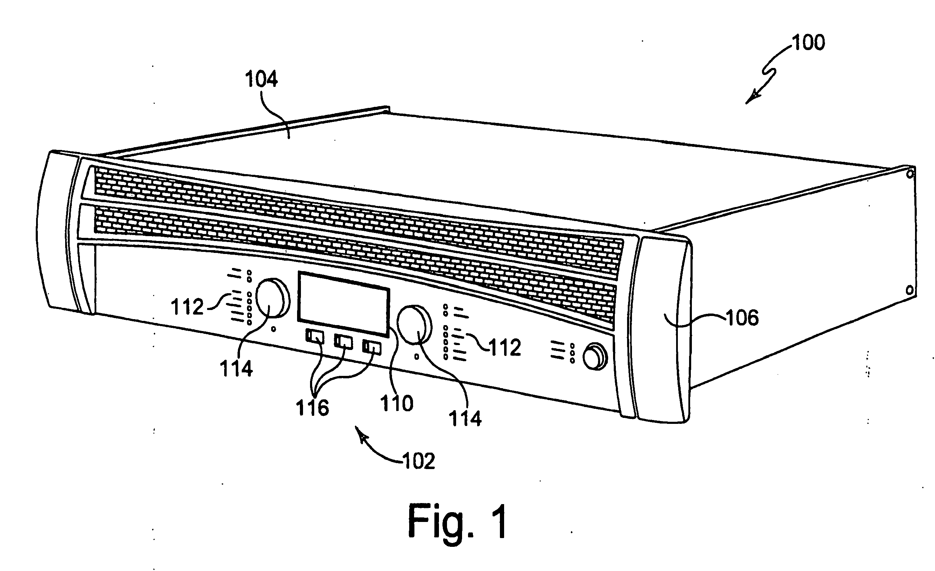

FIG. 1 is a perspective view of an example audio amplifier 100 that includes a local interface system 102. In the illustrated example, a housing 104 of the audio amplifier 100 includes a front panel 106. A portion of the local interface system 102 is mounted in the front panel 106. In other examples, the local interface system 102 may be mounted on a movable slide out panel, a recessed panel or any other form of mounting that is included as part of the audio amplifier 100.

The illustrated portion of the local interface system 102 is a user interface that includes visual indicators in the form of a display 110 and a plurality of indicators 112. In addition, the user interface includes user input devices in the form of a plurality of rotary encoders 114 and a plurality of buttons 116. In other examples, the visual indicators may be any mechanism providing visually recognizable information. Similarly, in other examples, the input devices may be any mechanism with the capability to accept user inputs. For example, a touch screen and stylus may be used.

The display 110 may be a liquid crystal display (LCD), cathode ray tube (CRT), plasma or any other similar mechanism capable of producing images, text and any other displayable parameters. The display 110 is a multiple line character display capable of displaying lines of text, as well as two or three-dimensional graphic images, charts, etc. Alphanumeric labels for each audio channel and/or the amplifier as a unit can be set through the user interface or remotely through network connected devices and displayed on the multi-line graphics display 110. The display 110 may also include a display backlight. The display backlight can be set through the local user interface or a remote interface to always be off, or turn off after a period of inactivity.

The indicators 112 may be light emitting diodes or other visual indicators capable of being selectively activated and deactivated by the local interface system 102. The rotary encoders 114 may be any device capable of producing signals indicative of user inputs. The illustrated rotary encoders 114 include the capability to freely rotate and provide signals indicative of rotation. In addition, the rotary encoders 114 may include pushbutton functionality by depressing each of the rotary encoders 114 to generate a signal into the local interface system 102.

The buttons 116 may be any mechanism capable of toggling a contact and/or signal when one of the buttons 116 is depressed. In the illustrated example, the buttons 116 are "soft buttons." The term "soft buttons" refers to a button with interchangeable functionality based on a dynamically adjustable definitions identified in the display 110. In other words, within different functional areas of the local interface system 102 that are displayed by the display 110, the buttons 116 may be identified within the display 110 as having various input functionality when actuated. Each of the buttons 116 may also include indicators such as imbedded LED indicators to provide visibility in low light conditions and/or to indicate when a displayed function is associated with one or more of the buttons 116. The rotary encoders 114 may also be configured as "soft rotary encoders" with interchangeable functionality depending on the screen on the display 110.

In addition, the buttons 116 may include a menu lockout button. The menu lockout button may provide a lockout command to prohibit local access to the local interface system 102 and therefore prevent adjustments via the user interface. In addition, the lockout button may prevent access to the configuration, settings, etc. of the amplifier 100 over the packet switched network.

The menu lockout button may be a hidden button, or may require a specialized tool to actuate. Alternatively, a password such as an alphanumeric code, biometric recognition such as voice recognition, fingerprint, retinal scan, etc. or any other form of user identification may be used to secure and limit access to the local interface system 102 and the amplifier 100 via the packet switched network.

An example configuration and functionality description of the visual indicators and user input devices of the example user interface may include:

**Left Rotary Encoder/Switch 114:**
- Push turns Main Select Screen on
- In Default Screen, controls CH1 Output Attenuator (unless linked, then controls both)
- In Menu Screens, controls scrolling of menu items up & down
- In label screens, moves next/previous character

**Right Rotary Encoder/Switch 114:**
- Push function
- In Default Screen, controls CH2 Output Attenuator (unless linked, then controls both) in 0.5db increments.
- In Menu Screens, controls scrolling of menu items up & down
- In label screens, controls character selection

**Buttons 116**
Left:
   - Select: Light indicates ability to select highlighted menu item
   - Clear: In Label screens, allows clearing of previous label to begin new label creation
   - Save: Allows saving of label and return to previous menu
Center:
   - Info: Displays the information for that particular menu item. Encoders allow scrolling of the information through the window
   - Back: Takes menu back to the previous menu item
Right:
   • Exit: From any menu location, takes the window back to the default screen

**Indicators 112:**
Power: Lights when the amplifier 100 on/off power switch is turned on.
Bridge: Lights when the amplifier 100 is in a Bridged mode.
Data: Lights when the data is being communicated over the packet switched network.
Fault: Indicates that an output channel of the amplifier 100 is in fault and not operating.
Thermal: Indicates that an output channel of the amplifier has exceeded a predetermined thermal limit and is not operating.
Clip: Indicates that the amplifier channel output has exceeded the set limit
   - 10: Indicates that an amplified audio output signal on an output channel of the amplifier 100 has exceeded a predetermined threshold, such as -10db from clip.
   - 20: Indicates that an amplified audio output signal on an output channel of the amplifier 100 has exceeded a predetermined threshold, such as -20db from clip.
Signal: Indicates that an amplified audio output signal on an output channel of the amplifier 100 has exceeded a predefined limit.
Ready: Indicates that the output channel(s) of the amplifier 100 are operating correctly and that the amplifier 100 is not in a standby mode.

The amplifier 100 may be secured against unauthorized access and/or manipulation by a plurality of security levels. Features may be included that allow the securing of certain amplifier controls that may be otherwise accessible through the packet switched network. In one example, the security may be implemented via instructions in amplifier that provide a plurality of objects (state variables) such as an internal password object, a password entry object and a secured flag object.

The secured flag object may be a read-only logical object that indicates whether the amplifier 100 is to be regarded as secured or not. In the secured state, software should treat certain "securable" objects (state variables) in a special fashion. Specifically, securable objects in a secured component may be hidden, such that a user cannot change or view the values associated with the secured objects. If the secured flag object is false, then all objects may be changed or viewed. In this example, the secured flag object is an indicator. In other examples, the secured flag object may be implemented as an instruction, a series of instructions or any other mechanism for limiting access to functionality within the amplifier.

The secured flag objects may be changed by interaction between other objects such as the internal password object. The internal password object may be a write-only text string that may only be written to in special circumstances. The password entry object may be a scratchpad text entry object that exists only as an area to enter a password. In this example, the secured object may be changed when the text entered into the password entry object matches the internal password object. The match may be necessary to change the secured object to secured or un-secured.

Other objects may also be tagged as "securable." These may be treated in a special fashion. In general, when an amplifier 100 is secured, objects that are marked as securable cannot be changed. Also, manipulation of these objects in any way that would expose their settings is not permitted. Such securable objects may be treated as "secured objects."

As a result of being identified as secured, controls that would ordinarily be used to monitor or control secured objects do not appear on the display 110. The settings of an object may also be omitted when ascertaining the values of a group of objects. In addition, the settings of secured objects may not be affected by changes that are made that would otherwise cause a change in the settings.

Examples of objects that may be identified as securable within the amplifier 100 include preset configurations stored in the amplifier 100, analog signal input ranges, analog input fader (sensitivity), digital input fader, peak voltage limiter gain reduction amounts, signal delay values, peak output limiter enabled indication, peak output limiter attack time, peak output limiter release time, peak limiter threshold ceiling, output inverter control and filters. Unsecured objects may also be made securable by a user.

In another example, the amplifier 100 may be configured with a first security level and a second security level. The first security level may provide access via the local interface system 102 and/or the network when a user is successfully authenticated by a first security access level. Within the first security level, an authenticated user may, for example, have access to view a predetermined group of operational parameters and manipulate a pre-determined group of configurable operational parameters, control parameters, setup parameters, etc. within the amplifier 100. The predetermined groups may be those parameters for which access can be provided without an undesirable disclosure of confidential amplifier settings, or allowing access to settings that could detrimentally impact operation if incorrectly manipulated.

The second security level may similarly allow access via the local interface system 102 or over the packet switched network upon successful authentication of a user by a second security access level. Access within the second security level may, for example, be unlimited. In other examples, any other number of security levels and corresponding levels of access may be configured. Thus, an owner of an amplifier 100, such as a sound system rental company may protect the amplifiers that are rented from being undesirably reconfigured. In addition, a musician of other user may maintain confidential settings and other operational parameters of an amplifier 100 without the need to limit physical access to the amplifier 100 itself.

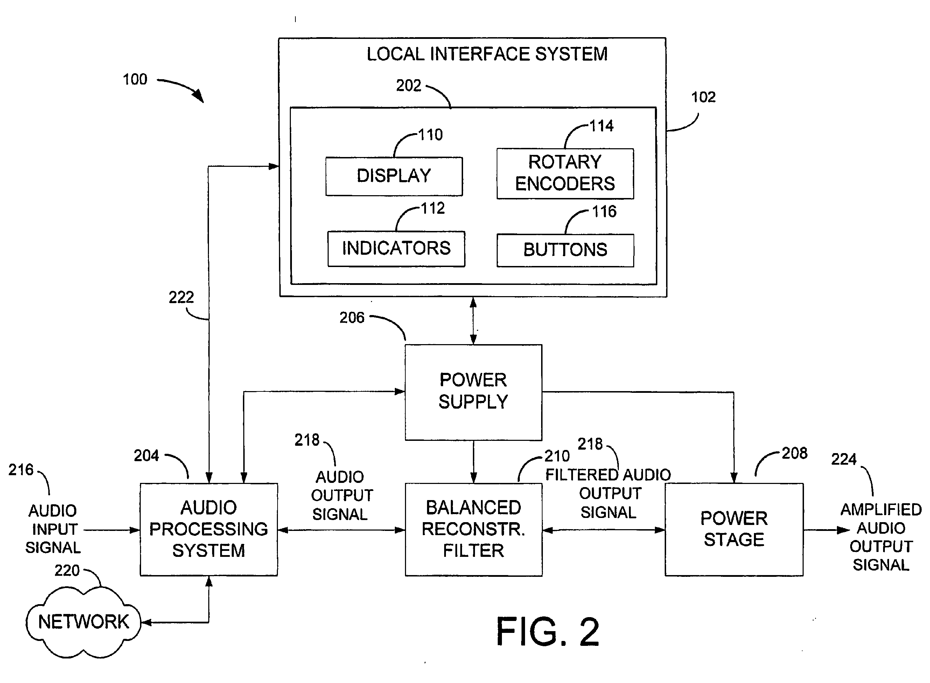

FIG. 2 is a block diagram of an example audio amplifier 100 that includes the local interface system 102. The local interface system 102 includes the display 110, the indicators 112, the rotary encoders 114 and the buttons 116 in a user interface 202. Also included in the example amplifier 100 is an audio processing system 204, a power supply 206, a power stage 208 and a balanced reconstruction filter 210. In the illustrated example, the local interface system 102 and the audio processing system 204 are illustrated as separate systems. In other examples, the functionality of the local interface system 102 and the audio processing system 204 may be combined, or further divided into additional systems. In addition, the balanced reconstruction filter 210 is illustrated as independent of the local interface system 102 and the audio processing system 204. In other examples, the balanced reconstruction filter 210 may be included in either the local interface system 102 or the audio processing system 204.

The audio processing system 204 is configured to process at least one audio input signal 216 to provide at least one audio output signal 218. The audio input and output signals 216 and 218 may be carried on one or more audio channels, such as a first channel (CH 1) and a second channel (CH 2) (not shown). The first and second channels (CH 1) and (CH 2) may represent left and right stereo channels. Alternatively, the first and second channels may represent a duplicated mono signal, or the mono signal and the mono signal that has been inverted.

The audio processing system 204 is also configured to interface the audio amplifier 100 to a switched packet network 220. Configuration, control and monitoring of the audio processing system 204 may be performed with either of the local interface system 102 or communication over the switched packet network 220. Accordingly, configuration and control related commands may be received by the audio processing system 204 over the packet switched network 220 and/or from the local interface system 102. Communication over the packet switched network 220 may be with any form of packet switched communication protocol.

Communication between the audio processing system 204 and the local interface system 102 may be over a communication link 222, such as an asynchronous serial interface. The asynchronous serial link may utilize transmit (TX) and receive (RX) communication protocol via universal asynchronous receiver-transmitters (UARTs) or other similar communication devices. The audio processing system 204 may therefore communicate between the user interface system 102 and the packet switched network 220. In this manner it may be possible for any other network connected device to send commands and data to the user interface system 102 via the audio processing system 204. Furthermore, commands and data may be sent via the packet switched network 220 and the audio processing system 204 to edit and/or replace instructions stored in local system interface 102 without physical interaction by a user with the user interface 202.

The power supply 206 may be any form of power supply capable of providing the necessary magnitude(s) and quantity of DC power to the local interface system 102, the audio processing system 204, the balanced reconstruction filter 210 and the DC rails of the power stage 208. The power supply 206 may receive an AC input voltage from an AC power source. In addition, the power supply 206 may provide signals representative of line voltage magnitude, a signal representative of the temperature of the power supply 206, and a power supply current signal indicating the magnitude of the output current of the power supply 206.

In one example, the power supply 206 is a regulated switch-mode power supply with power factor correction such as those described in EP 1501177 (U.S. Patent Application Serial No. 10/626,433) to Stanley entitled "Opposed Current Converter Power Factor Correcting Power Supply" or US 2005/017689 (U.S. Patent Application Serial No. 10/616,149) to Stanley entitled "Series Interleaved Boost Converter Power Factor Correcting Power Supply".

The power stage 208 is the amplification stage within the audio amplifier 100 that increases the magnitude of the processed audio output signals 218. Amplified audio output signals 224 may be provided as an output from the power stage 208. In one example, the amplified audio output signals 224 may be provided on a first channel (CH 1) and a second channel (CH 2) to drive separate loads such as a first and second loudspeaker when the amplifier 100 is configured to operate in the stereo mode. Alternatively, when the amplifier 100 is configured to operate in the mono mode, the first and second channels (CH 1 and CH 2) of the power stage 208 may be coupled in series to drive a single load such as a loudspeaker. In other examples, the power stage 208 may provide any number of channels to drive separate and independent loads.

The power stage 208 includes a switching amplifier output stage and an output filter (not shown). The output filter has a frequency response that is affected by a load powered by the power stage. Accordingly, the output filter has a frequency dependent output impedance. The power stage 208 may include an opposed current power converter as described in U.S. Patent No. 5,657,219 to Stanley entitled "Opposed Current Power Converter" . Alternatively, the power stage 208 may include any other form of pulse width modulated switch mode, or output stage for an audio power amplifier. In one example, the output stage is capable of producing amplified output signals in a range of about 1250 watts to about 8000 watts depending on the configuration of the amplifier 100 and the load being driven by the power stage 208.

The balanced reconstruction filter 210 is a digital to analog reconstruction filter that is balanced to minimize common mode noise within the amplifier 100. Instead of increasing the gain of the power stage 208 as the drive voltage of the power stage 208 is increased, the balanced reconstruction filter 210 is employed. In general, the balanced reconstruction filter 210 includes two halves that share the work that would otherwise be performed by a single ended filter. Thus, the voltage and current experienced by the components within the balanced reconstruction filter 210 is divided since the signal magnitude of processed audio output signal 218 is split between the two halves. Accordingly, higher magnitudes of drive voltage do not exceed the rating of components within the balanced reconstruction filter 210.

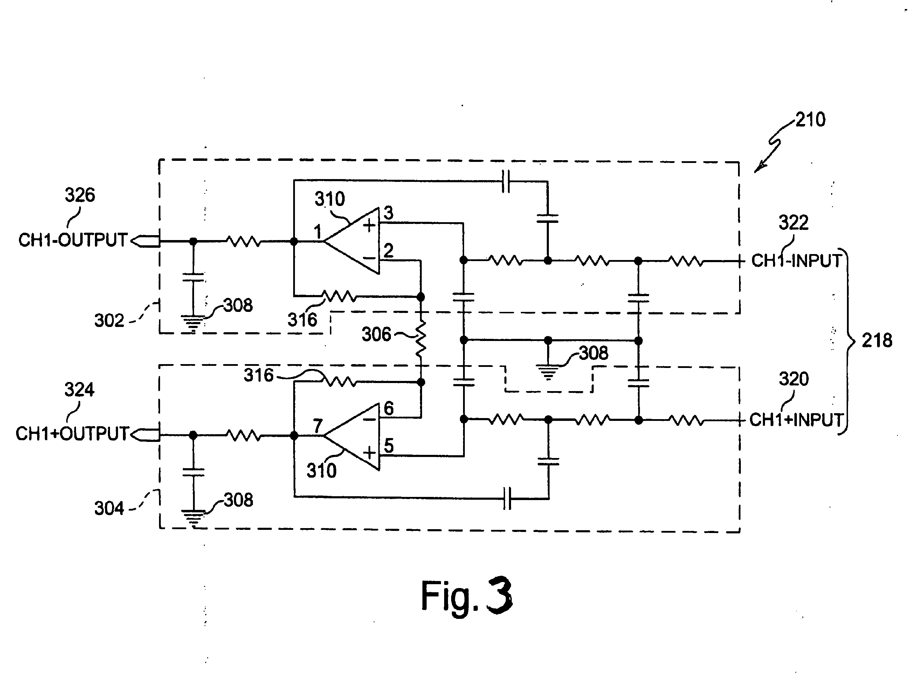

FIG. 3 is an example circuit schematic of a balanced reconstruction filter 210. The balanced reconstruction filter 210 includes a first subfilter 302 and a second subfilter 304 as the two halves. In addition, the balanced reconstruction filter 210 includes a gain setting resistor 306. The gain setting resistor 306 is shared between the first and second subfilters 302 and 304 and is configured to maintain a balance of current and voltage in the two halves. Thus, the first and second subfilters 302 and 304 include self correcting balancing to maintain the voltage and current flow in the respective subfilters 302 and 304 about equal. A ground connection 308 is also common between the first and second subfilters 302 and 304.

Each of the first and second subfilters 302 and 304 include an amplifier 310, a plurality of resistors 312, a plurality of capacitors 314 and a plurality of feedback resistors 316. The amplifier 310 may be a low noise bipolar operational amplifier such as a NJM2043M by New Japan Radio Co. (JRC). The feedback resistors 316 are of about equal resistance to provide further balancing between the first and second subfilters 302 and 304. The configuration of the amplifier 310, the resistors 312 and 316, and the capacitors 314 in each of the first and second subfilters may be similar to a 3^{rd} order Sallen and Key filter design criteria.

During operation, one of the audio output signals 218 is provided to the balanced reconstruction filter 210. The audio output signal 218 is a balanced input signal having a positive channel (CH 1+) 320 and a negative channel (CH 1-) 322. Accordingly, where there are multiple audio output signals 218, a like number of balanced reconstruction filters 210 may be provided.

The portion of the audio output signal 218 that is the positive channel 320 is provided to the first subfilter 304 and the portion of the audio output signal 218 that is the negative channel 322 is provided to the second subfilter 306. As such, the magnitude of the voltage and the current of the audio output signal are divided between the first subfilter 304 and the second subfilter 306. Since the magnitude of voltage and current is effectively halved, the gain of the power stage 208 may remain the same as the magnitude of the driving voltage of the audio output signal 218 is increased. As a result, the signal-to-noise ratio may be improved. Following filtering, the filtered audio output signal 218 is provided as an input to the power stage 208 as the combination of a positive channel 324 and a negative channel 326.

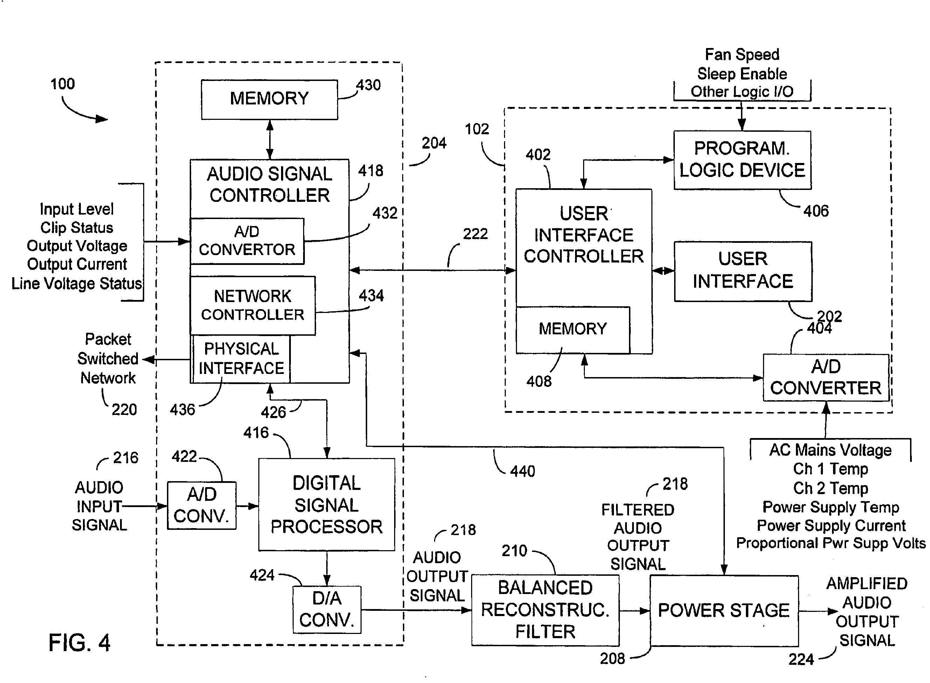

FIG. 4 is an example of a more detailed block diagram of the audio amplifier 100 that includes the local interface system 102, the audio processing system 204, the power stage 208 and the balanced reconstruction filter 210. The local interface system 102 may include the user interface 202, a user interface controller 402 an analog-to-digital (A/D) converter 404 and a program logic device 406. In other examples, the local interface controller 402 may be omitted and the functionality of the local interface controller 402 may be performed elsewhere in the amplifier 100.

The user interface controller 402 may be any processor capable of executing instructions stored in a memory device 408 to direct the functionality of the local interface system 102. In the illustrated example, the local interface controller 402 includes an on-board memory device 408 to store the instructions and operational data associated with the audio amplifier 100. In other examples, a separate memory device (not shown) such as flash memory, random access memory (RAM) or any other form of electronic memory may be disposed in the audio amplifier 100 for storage of the instructions and operational data. The local interface controller 402 is an integral part of the audio amplifier 100.

Referring now to FIGs. 1 and 4, the user interface controller 402 may be configured to receive the user inputs, such as the rotary encoders 114 and the buttons 116 discussed with reference to FIG. 1. In addition, the user interface controller 402 may provide outputs to drive the display 110 and the indicators 112. In one example, the instructions stored in the memory 408 may be executed by the user interface controller 402 to display a plurality of menu screens in the display 110.

An example series of menu screens and associated inputs and outputs includes:

**A Default Menu:**
- Displays the attenuator settings of both audio channels.
- Amplifier may default back to this screen after a determined time of controls not being used.
- Displays user input labels, whether static, banners, or scrolled, as selected.

**A Choice Menu:**
This may be the initial menu chosen by pressing the one of the buttons 116 while in the Default Menu to provide for a choice of the three main menus: Monitor, Settings, and Display.

**A Monitor Menu:**
- CH1 TEMP: Indicates temperature of CH1 amplifier in 1°C increments from 0°C to +100°C.
- CH2 TEMP: Indicates temperature of CH2 amplifier in 1°C increments from 0°C to +100°C.
- PS TEMP: Indicates temperature of the power supply 206 in 1°C increments from 0°C to +100°C.
- INT TEMP: Indicates temperature of the interior of the amplifier 100 in 1°C increments from 0°C to +100°C.
- AC MAINS: Indicates the voltage of the AC Mains supplying the power supply 206 in a range of 90VAC to 260VAC in 1VAC increments.
- CH1 Load: Displays the measured load impedance from 0Ω to 255Ω in 1Ω increments of a load coupled with the power stage 208.
- CH2 Load: Displays the measured load impedance from 0Ω to 255Ω in 1Ω increments of a load coupled with the power stage 208.
- FAN1 SPD: Indicates the Fan 1 speed in RPM from 0rpm to 10,000rpm in 100rpm increments.
- FAN2 SPD: Indicates the Fan 2 speed in RPM from 0rpm to 10,000rpm in 100rpm increments.
- OP HRS: Indicates how many hours that the amplifier 100 has been powered up including standby in determined increments, such as 1 hr increments.
- SN#: Indicates the Serial Number of the amplifier 100.

**A Settings Menu:**
- CH1 Label: The 8 character label associated with CH1. Default= CH1.
- CH2 Label: The 8 character label associated with CH2. Default= CH2.
- AMP Label: The 16 character label for the amplifier.
- ATTN LINK: Toggles linking of attenuation control of audio output channels. When "ON', attenuation of all audio output channels are attenuated together. Default= OFF.
- CH1 SENS: Indicates the sensitivity between 0db to -80db in 0.5db increments. Default=0.0db.
- CH2 SENS: Indicates the sensitivity between 0db to -80db in 0.5db increments. Default=0.0db.
- ATTN1 LMT: Sets the upper limit for attenuation of the audio output signals. 0db to -80db in 0.5db increments. Default=0.0db.
- ATTN2 LMT: Sets the upper limit for attenuation of the audio output signals. 0db to -80db in 0.5db increments. Default=0.0db.
- BRIDGE MODE: Places the amplifier into either "STEREO" or "MONO" modes. Default=STEREO.
- INPUT Y:- configures the amplifier for single audio input that is supplied to both channels as the audio input signals Default=OFF.
- CLIP COMP: Turns the Clip Compressor on. Default= OFF.
- SLEEP: Enables a Sleep Mode. Default= OFF.
- LED SRC: Chooses source for amplifier signal LED's. Default=INPUT.
- LANGUAGE: Chooses language for display. English, French, German, Spanish. Default=ENGLISH.
- CONTRAST: Determines contrast of the display in 16 steps. 16= full contrast, 0= no contrast. DEFAULT=16.
- B/L SLEEP: Backlight Sleep Time. Indicates duration of time after no control functions that the display backlight turns off. 0 sec to 300 sec in 1 sec increments. Default=60 sec.
- PASSWORD: sets a unique code to allow local access Default=OFF.
- CLIP LIM: Sets the Clip LED sensitivity. 0db to -80db in 0.5db increments. Default=0.0db.
- SPI LIM: Sets the Signal Presence Indicator LED sensitivity. 0db to - 80db in 0.5db increments. Default=60db.
- ERR RPT: Turns the error reporting on/off. Default=OFF.
- ERR LOG: Activates, deactivates and resets the Error Log.

**Display Menu:**
Each item available for display may be configured to be displayed. In addition, each item may be configured as to how it will be displayed. Example choices that are selectable for each item include:
   - NONE: The item is not displayed on the Default Menu Screen
   - BANNER UP: The item is displayed on the top of the Default Menu Screen. If multiple items are chosen, then the selected items alternate.
   - BANNER DOWN: The item is displayed on the bottom of the Default Menu Screen. If multiple items are chosen, then the selected items alternate.
   - SCROLL UP: The item is scrolled across the top of the Default Menu Screen. If multiple items are chosen to be scrolled, they are scrolled in succession.
   - SCROLL DOWN: The item is scrolled across the bottom of the Default Menu Screen. If multiple items are chosen to be scrolled, they are scrolled in succession. If some items are chosen to be scrolled, and others banner, then the scrolling and banners are alternated.

Referring again to FIG. 4, the A/D converter 404 may be any device(s) capable of converting analog signals to digital signals. The programmable logic device (PLD) 406 may be any integrated circuit capable of being programmed to perform complex functions. Within the audio amplifier 100, the PLD 406 may be programmed to process digital inputs and provide digital outputs. Specifically, the PLD 406 may be programmed to include the functionality of a de-multiplexer, an input latch, an output latch and a synchronous serial interface (SSI). With this functionality, the PLD 406 may function primarily as an I/O port expander for the user interface controller 402 and communicate with the user interface controller 402 over an SSI communication bus.

The audio processing system 204 includes a digital signal processor (DSP) 416 and an audio signal controller 418. The digital signal processor 416 may be any form of fully digital processor that executes instructions, logic task and/or operating code to perform calculations and/or any other tasks related to digital information or analog information that has been converted to digital form within the amplifier 100. The DSP 416 may be, for example, a 32 bit Sharc™ digital processor by Analog Devices. The DSP 416 may be programmed to process the audio input signals 216 by filtering, delaying, scaling and otherwise managing and manipulating the audio input signals 216 to create the audio output signals 218.

The DSP 416 may filter the audio input signals 216. In one example, the DSP includes sixty four assignable filters that may be selectively applied. The filters may include a plurality of selectable filter types such as, allpass (crossover), lowpass, highpass, bandpass, peak or notch, treble shelving, base shelving and/or other audio filter functions. In addition, delay, such as over two seconds of delay, may be configured. Further, dual uncorrelated-noise and sine-wave generators may be implemented within the DSP 416.

Alternatively, or in addition, a filter circuit may be included between the DSP 416 and the power stage 208. The filter circuit may include an analog filter providing frequency response compensation for each audio output signal 224 provided by the power stage 208. The frequency response circuit may be adjusted to correct for gain mismatches in the power stage 208. In addition the filter circuit may include a high pass filter providing filtering of the amplified output audio signals and DC offset correction of the amplified output audio signals. The high pass filtered and DC offset corrected amplified audio output signals may be provided to the audio signal controller 418 as feedback signals from the power stage 208.

The DSP 416 may also be configured to provide scaling of the audio input signals 216 by adjusting the gain applied to the audio input signals 216. For example, the DSP 416 may include a variable gain stage (not shown) that is capable of attenuating the audio input signals 216 supplied on a first channel (CH 1) and a second channel (CH 2). Attenuation of the variable gain stage may be controlled with a gain setting. The gain setting may be dynamically adjusted by the DSP 416 during operation. In addition, the DSP 416 may control processing of the audio input signals to advantageously affect amplification of the audio signals by the power stage 208. Further, the DSP 416 may provide digital outputs to directly control the power stage 208 such as with the control scheme(s) described in US Patent No. 6,683,494 to G. Stanley entitled "Digital Signal Processor Enhanced Pulse Width Modulation Amplifier" .

The DSP 416 may also be capable of configuring the amplifier 100 to operate in different operational modes. The operational modes may involve various channel configurations of the signal paths through the DSP 416, such as a stereo mode and a mono mode. In the stereo mode, separate audio input signals 216 supplied on the first channel (CH 1) and the second channel (CH 2) may be separately processed and provided as audio output signals 218. In the mono mode, the DSP 416 may be reconfigured in a bridge mode so that only one audio input signal 216 provide on the first channel (CH 1) may be inverted and provided on the second channel (CH 2). Accordingly, the audio output signals 218 are a processed audio input signal and an inverted processed audio input signal that are provided to the power stage 208. Thus, the first and second channels may be connected in series, and a load supplied by both the first and second channels may receive a mono signal.

The DSP 416 may also be configured in a Y switch mode. In the Y switch mode, a single audio input signal 216 on the first channel (CH 1) may be processed and provide as output audio signals 218 on both the first channel (CH 1) and the second channel (CH 2) to the power stage 208. Filter configurations to provide studio quality dynamics and frequency shaping may also be configured in the DSP 416.

The audio input signals 216 may be received and converted to digital signals by an A/D converter 422 as part of the processing by the DSP 416. When the audio input signals 216 are already in digital form when received by the amplifier 100, however, the A/D converter 422 may be omitted. When the A/D converter 422 is omitted, the digital audio input signals may have the same sample rate as the DSP 416, or may include clocking information. Alternatively, a sample rate converter or other similar conversion device may be used. A digital-to-analog converter 424 may convert the digital signals processed by the DSP 416 to the analog domain to form the audio output signals 218.

Control and processing by the DSP 416 may be based on the audio input signals 216 and/or operational parameters that are available as digital inputs to the DSP 416. Digital inputs, such as amplifier operational parameters, parameters related to the amplified output signals 224, external signals brought into the amplifier 100, etc. may be provided directly to the DSP 416. In addition, operational parameters and control signals may be provided by the audio signal controller 418 to the DSP 416 over a communication interface 426. The communication interface may be any form of communication, such as a synchronous serial interface (SSI) bus.

The audio signal controller 418 may be any form of processing device(s) with network communication and input/output capability. In addition, the audio signal controller 418 may be any form of processor capable of executing instructions, logic tasks and/or operating code to manage overall functionality, perform calculations, control inputs/outputs, etc. related to processing of audio signals within the audio amplifier 100. In the illustrated example, the audio processing system 204 includes a memory device 430 coupled with the audio signal controller 418.

The memory device 430 may be any form of data storage device that is capable of storing instructions, data and operational parameters related to the amplifier 100. The audio signal controller 418 may execute instructions stored in the memory device 430. In addition, the audio signal controller 418 may store operational parameters and any other information received over the communication link 222 from the local interface system 102 in the memory device 430. Accordingly, operational logs, diagnostics, error logs, etc. may be compiled by the audio signal controller 418 and stored in the memory device 430. Alternatively, such operational information may be compiled and/or stored by the user interface controller in the memory 408, or in any other memory device. In still another alternative, operational information may be communicated over the packet switched network 220 and stored remotely for later access by the amplifier 100.

The audio signal controller 418 may also include an A/D converter 432 to receive analog signals indicative of operational parameters related to the operation of the amplifier 100. The A/D converter 432 may be a Cirrus Logic 24-bit/96kHz delta-sigma converter. The analog signals may be received by the audio signal controller 418 via the A/D converter 432. In the illustrated example, the audio signal controller 418 receives an input level of the audio input signals 216. In addition, the audio signal controller 418 receives the status of whether the DSP 416 is currently clipping the audio output signal 218 due to amplifier audio distortion, heat, etc. The audio signal controller 418 may also receive the output voltage and current of each amplified audio output signal 224. A line voltage status such as a current and voltage indication from the power supply 206 (FIG. 2) may also be received by the audio signal controller 418. Alternatively, a contact closure indication from the power supply 206 (FIG. 2) indicating the supply voltage is in a predetermined range or some other form of indication may be received by the audio signal controller 418.

In addition to updates to the instructions executed by the DSP 416, the audio signal controller 418 may also provide operational parameters that may be used by the DSP 416 during processing of the audio input signals 216. Settings, control signals or any other processing related parameters may be communicated to the DSP 416 by the audio signal controller 418. The settings may include filter configurations, delays, channel configurations, etc. The control signals may include gains for the variable gain stage, filter adjustments, etc.

The audio signal controller 418 may also control processing by the DSP 416 by executing instructions during processing of the audio input signals 216. The audio signal controller 418 may direct the DSP 416 to scale, filter and otherwise modify the input audio signals 216 provided to the audio amplifier 100. For example, the audio signal controller 418 may dynamically adjust the scale during processing of the audio input signals 216 based on the output voltage and current of the amplified audio output signals 224 provided by the power stage 208.

In addition, the amplified audio output signals 224 may be received and buffered by the audio signal controller 418. The audio signal controller 418 may compared the amplified audio output signals 224 to a determined threshold, such as -40dB, that is stored in the memory 430. When the threshold is exceeded, a signal presence signal may be communicated by the audio signal controller 418 to the user interface controller 402. In response to receipt of the signal presence signal, the user interface controller 402 may illuminate a Signal Presence Indicator (SPI) in the indicator array 112.

In another example, the audio signal controller 418 may dynamically adjust the gain of the variable gain stage included in the DSP 416 based on the magnitude of the supply voltage and current provided to the power supply 206 (FIG. 2). Accordingly, the audio input signals 216 may be attenuated to control the current drawn by the power supply 206. This control may be implemented where voltage drop in the supply line providing the supply voltage to the power supply 206 is aggravated by increasing current demands of the power supply 206. Instead of the amplifier 100 eventually shutting down due to increasing current demand, and resulting lower voltage, the audio input signals may be attenuated by the audio signal controller 418 to reduce current consumption by the power supply 206.

The DSP 416 may also be directed by the audio signal controller 418 to dynamically adjust the processing of the audio input signal 216 to optimize the frequency response of the power stage 208. Dynamic or automated adjustment may involve changes to the filtering, the delay or any other frequency related processing being performed by the DSP 416.

The audio signal controller 418 may monitor the output current and voltage of the amplified output signals 224. Based on predetermined operating characteristics, the frequency response of the power stage 208 may be optimized. For example, a loudspeaker with a known distortion characteristic that varies as a result of heating caused by the magnitude of amplified audio output signal may be compensated. In this instance, the audio signal controller 418 may dynamically adjust the filtering to include pre-distortion in the amplified audio output signals 224. The pre-distortion may provide a canceling effect on the distortion created by heating. Thus, the frequency response of the power stage may be optimized.

In another example, a loudspeaker may provide less audible sound below a determined frequency threshold. The audio signal controller 418 may dynamically adjust the filtering performed during processing by the DSP 416 when the audio input signal falls below the frequency threshold to optimize the frequency response of the power stage 208.

The DSP 416 and the audio signal controller 418 may also cooperatively operate to dynamically perform diagnostics and calibration of the audio amplifier 100 to optimize the frequency response of the power stage 208. For example, the DSP 416 and the audio signal controller 418 may dynamically tune the filtering of the audio input signals 216 based on the amplified audio output signals 224. The audio signal controller 418 may store in memory 430 a tuning tone that is predetermined audio input signal. The tuning tone may be at a frequency that is out of the range of human hearing, or may be an audible click or may be any other program material capable of being processed and amplified.

During startup, at a predetermined time, or during some other diagnostic event that could be initiated automatically or manually, the audio signal controller 418 may provide the tuning tone to the DSP 416. The DSP 416 may process the tuning tone to form an audio output signal 218. The audio output signal 218 may be filtered by the balanced reconstruction filter 210 and amplified by the power stage 208 to produce an amplified audio output signal 224.

The audio signal controller 418 may monitor the current and voltage magnitude of the amplified audio output signal 224 produced based on the tuning tone. The audio signal controller 418 may also have stored in the memory 430 predetermined amplified audio output signals that are expected from the processing and amplification of the tuning tone. Accordingly, the audio signal controller 418 may compare the stored predetermined amplified audio output signals to the actual amplified audio output signals produced based on the tuning tone.

Based on response errors between the predetermined audio output signals and the actual amplified audio output signals, the audio signal controller 418 may manipulate the filtering within the DSP 416 to tune the frequency response of the power stage 208. More specifically, the filtering may be manipulated to make frequency dependent magnitude adjustments to the audio input signals 218. Such tuning may provide dynamically optimized filtering that may correct for power stage 208 mismatches in gain on the individual channels. In addition, tuning may compensate for the actual load, such as loudspeakers, being driven by the amplifier 100. Further, equalization adjustments may be performed so that the frequency response of power stage 208 may be made substantially flat. Accordingly, the DSP 216 may be automatically tuned by the audio signal controller 418 to create an intended response.

The audio signal controller 418 may also include a network controller 434 such as an Ethernet controller. The network controller may provide packet switched communication capability to communicate over the packet switched network 220 using a physical interface 436. The physical interface 436 may be a network compatible integrated circuit or other similar device. Communication over the packet switched network 220, such as an IQ network, may be accomplished using for example, an Ethernet communication protocol as described in US Patent No. 5,862,401 to Barclay entitled "Programmable Central Intelligence Controller and Distributed Intelligence Network for Analog/Digital Control Systems". In addition, a transmission control protocol (TCP) such as TCP/IP may be used.

Network communication may allow inputs and/or outputs of the audio amplifier 100 to be controlled or monitored remotely utilizing the audio processing system 204. Accordingly, the audio signal controller 418 may include capability to translate between I/O within the audio amplifier 100 and the protocol used for communication over the packet switched network 220. The audio signal controller 418 may therefore allow remote monitoring of operational parameters within the audio amplifier 100 via the packet switched network 220. In addition, the combination of the digital signal processor 416 and the audio signal controller 418 may allow remote control of the audio amplifier 100 via the packet switched network 220. It should be noted that audio amplifiers may not always be the only devices on the network. It is possible for any device that conforms to the communications protocol of a packet switched network 220 to communicate over the network with the audio amplifier 100.

As previously discussed, control and communication functions may be provided by the audio processing system 204. The audio processing system 204 may control a standby command status of each amplifier channel. The standby command may manually or automatically place the audio amplifier 100 in a standby mode during extended periods of inactivity. The standby command may be provided over the packet switched network 220 or from the user interface 202 (FIG. 2) of the local interface system 102. In the standby mode, the audio signal controller 418 may direct the power stage 208 to suspend switching of the switch mode output stage. The power stage 208 may be instructed with a suspend command transmitted over an output stage control line 440. The audio signal controller 418 may also communicate that the amplifier 100 is in the standby mode with a standby signal provided to both the local interface system 102 and the digital signal processor 416. In response to the standby signal, the user interface controller 402 may illuminate one of the indicators 112. In addition, both the user interface controller 402 and the audio signal controller 418 may identify errors in audio amplifier 100 operation during standby mode.

The user interface controller 402 also has capability to receive input signals and provide output signals (I/O). The input and output signals may be digital signals and/or converted analog signals. The user interface controller 402 may receive inputs from the audio amplifier 100, the user interface 202, the A/D converter 404, the programmable logic device 406 and/or the power supply 206 (FIG. 2). The magnitude of line voltage (AC mains voltage), thermal data, the power supply current and a proportional power supply voltage may be received from the power supply 206 via the A/D converter 404. In addition, the temperature of heat sinks in the power stage 208 for each of the amplified output signals 224 (CH1 and CH 2) may be received by the user interface controller 402 via the A/D converter 404.

The A/D converter 404 performs analog-to-digital conversion of the temperature of the first and second audio channels as well as the internal temperature of the power supply 206. The converted analog signals may then be provided to the user interface controller 402 via the SSI bus. In addition, the line voltage and power supply current may be converted and provided to the user interface controller 402 via the SSI bus. Additional operational parameters received by the user interface controller 402 may include power stage 208 standby status indication, ambient temperature inside of the housing 104 (FIG. 1), etc.

The user interface controller 402 may also control functions of the audio amplifier via the programmable logic device (PLD) 406. In the illustrated example, functions controlled with the user interface controller 402 via the programmable logic device 406 include cooling fan speed, sleep enable and other logic related I/O.

As previously discussed, the PLD 406 may be programmed with the functionality of a de-multiplexer, an input latch, an output latch and a synchronous serial interface (SSI). "Parallel" inputs and outputs may be latched by the PLD 406 and read by the user interface controller 402 serially over the SSI bus. The output latch functionality of the PLD 406 may convert data sent serially from the user interface controller 402 via the SSI bus. The data may be converted by the output latch to parallel digital data that can control various aspects of the audio amplifier 100. In the illustrated example, the output latch functionality in the PLD 406 sends control signals to control a fan speed of cooling fans, enables a sleep mode and provide various other control signals as directed by the user interface controller 402.

The user interface controller 402 may control the speed of one or more fans positioned within the audio amplifier 100 to provide convection cooling. The fan speed may be varied over a plurality of speeds. In one example, the PLD 406 is dynamically provided four bits by the user interface controller 402 to vary the speed of the fans. Based on the bit configuration, the rotational speed of the fans may be varied by the PLD 406 by varying the magnitude of the power supplied to the fans.

The input latch functionality may convert digital output signals received by the PLD 406 into serial data that can be accessed by the user interface controller 402 via the SSI bus. For example, the input latch functionality may monitor the status of contact closures and other digital signals within the audio amplifier 100. Another functionality of the PLD 406 may be to de-multiplex enable control lines that are included as part of the SSI bus. The user interface controller 402 may "talk" to other devices, such as the A/D converter 404 via the SSI bus by enabling a particular device through a determined identifier, such as a two bit encoded number. The de-multiplexer may be used by the PLD 406 to identify communication from the user interface controller 402 for the PLD 406.

Inputs and outputs related to the user interface 202 may also be controlled and monitored with the user interface controller 402. The monitored and controlled inputs and outputs include image display control on the display 110 (FIG. 1), indication control on the indicators 112 (FIG. 1), sensing of actuation of the rotary encoders 114 (FIG. 1), sensing of actuation of the buttons 112 (FIG. 1) and sensing of actuation of a menu lock out button.

The user interface controller 402 may also include I/O in the form of communication protocols such as the previously discussed asynchronous communication with the audio signal controller 418 and the PLD 406. In addition to communication and/or I/O exchanges directly with the audio signal controller 418 via the communication link 222, the user interface controller 402 may also communicate via the audio signal controller 418 over the packet switched network 220. Accordingly, the I/O of the user interface controller 402 may be monitored and controlled remotely similar to the audio signal controller 418. In addition, reprogramming and modification of the user interface controller 402 may be performed over the network using the audio signal controller 418 and the communication link 222.

Serial communication with the audio signal controller 418 via the communication link 222 may make inputs to the user interface controller 402 available to the audio signal controller 418. Similarly, inputs to the audio signal controller 418 may be available to the user interface controller 402. Accordingly instead of separately receiving the same signals, signal(s) may be received by one controller and transmitted via the communication link 222 to the other controller.

The outputs of the user interface controller 402 may also be available to the audio signal controller 418, and vice-versa. In addition, the user interface controller 402 may direct processing of the DSP 416 via the audio signal controller 418. Conversely, the audio signal controller 418 may be capable of controlling aspects of the user interface controller 402 and the display 110 (FIG. 1), such as providing operational parameters, diagnostics, error logs or reports on the display 110, or activating an indicator 112 (FIG. 1).

Control and monitoring of the audio amplifier 100 by the audio processing system 204 may also be performed with a remote personal computer over the packet switched network 220. Local control may also be performed with the user interface controller 402. Use of the user interface controller 402 avoids the need for manually adjustable switches and buttons that are physically implemented on the audio amplifier 100 back or front panel. With only manually adjustable switches and buttons, it was left to the user to properly setup the audio system for optimum performance, and ensure the settings are not changed by unauthorized users.

With the combination of the user interface controller 402 and the audio processing system 204, any setting changes may be implemented without requiring the user to physically adjust switches at each system component. Settings may also be cut and pasted (copied) between audio amplifiers 100 from the local interface system 102 through use of the packet switched network 220. Alternatively, settings may be implemented with a setup wizard. Security settings such as passwords, etc. may also be enabled with the user interface controller 402 to limit access to the settings of the audio amplifier as previously discussed.

The display 110 (FIG. 1 and 2) may also be used to perform functions locally that were not previously available at the audio amplifier 100. Settings, amplifier status and custom configuration may all be performed locally at the audio amplifier 100 using the local interface system 102. In addition, access to the network via the audio signal controller 418 may be performed with the display 110. Functions may be made available at the display 110 via a series of menu screens as previously discussed.

Utilizing the display 110 (FIG. 1 and 2), error reports can be viewed at the audio amplifier without a personal computer or other externally connected computing device. In addition, error logging may be enabled and disabled with the display 110. Further, audio channels within the audio amplifier 100 may be uniquely identified with an identifier such as numbers and/or letters. The identifier may be stored in memory 408 and/or 430 and accessed locally via the display 110 during operation of the audio system in which the audio amplifier 100 is operated.

The DSP 416 may receive audio input signals 216 on first channel and a second channel. The DSP 416 includes a first variable gain stage and a second variable gain stage that correspond to the first and second channels, respectively. The first variable gain state is capable of adjusting gain of the audio input signal provided on the first channel. The second variable gain state is capable of adjusting the gain of the audio input signal provided on the second channel. The gain of the first and second gain stages may be adjusted with gain commands provide by either the local interface system 102 or gain commands provide over the packet switched network 220.

Adjustment of the first and second variable gain stages may be performed by the user interface controller 402 based on adjustments via the menu screens of the display 110 (FIG. 1 and 2). Gain commands to adjust the variable gain stages may be communicated through the communication link 222 and the audio signal controller 418 to the DSP 416. In addition, gain commands may be communicated over the packet switched network 220 through the audio signal controller 418 to the DSP 416. In this manner gain commands to adjust the variable gain stages may be sent from other network connected devices via the audio signal controller 418. The audio signal controller 418 may also use the variable gain stages to dynamically adjust amplifier gain based on variables provided as inputs to either of the user interface controller 402 or the audio signal controller 418.

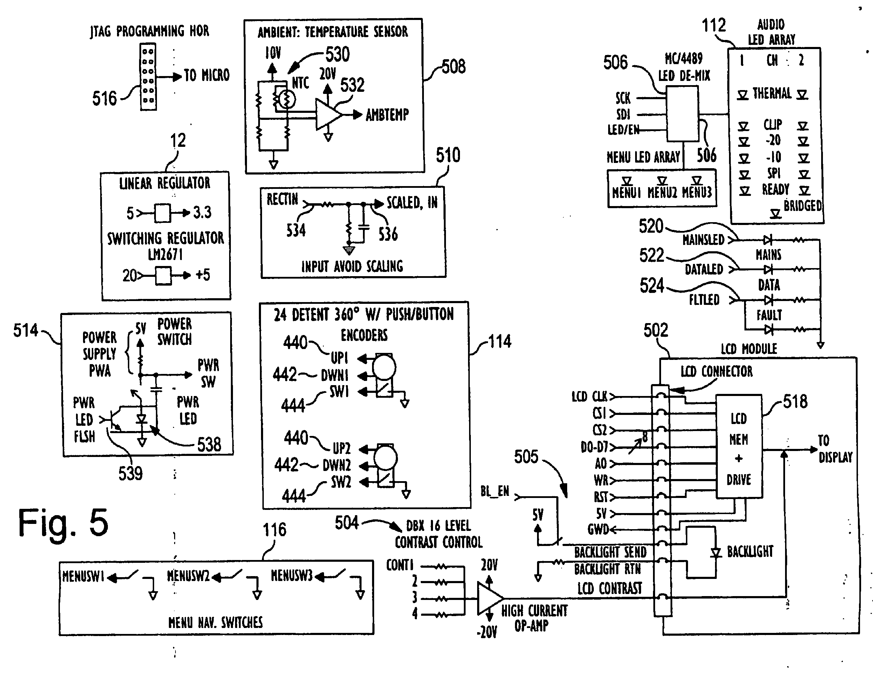

FIG. 5 is a circuit schematic of example hardware included in the local interface system 102. The illustrated circuit schematic includes a display driver circuit 502, a contrast control circuit 504 supporting the display 110 (FIG. 1) and an indicator driver circuit 506 supporting the indicators 112. Also included in the circuit schematic are the rotary encoders 114 and the buttons 116. In addition, an ambient temperature sensor 508, an audio scaling circuit 510, a low voltage regulator circuit 512, a power switch circuit 514 and a data port 516 are illustrated.

The display driver circuit 502 may be any circuit capable of driving the display 110 based on control signals from the user interface controller 402 (FIG. 4). In the illustrated example, the display 110 (FIG. 1) being driven by the display driver circuit 502 is a liquid crystal display (LCD). Accordingly the display driver circuit 502 includes an LCD memory and driver 518. The contrast control circuit 504 may provide control of the contrast in the display 110 via the menu screens produced on the display 110. In addition, a backlight control 505 may also be included.

The indicator driver circuit 506 may be any device capable of driving at least a portion of the indicators 112 (FIG. 1) based on control signals from the user interface controller 402. The example indicators are LEDs in an LED array, thus the indicator driver circuit 506 may be a multiplexing LED driver such as a Motorola MC14489 to actuate indicators such as "thermal", "clip", "-20 db", "-10db", "signal", "ready" and "bridged" as previously described.

The indicator driver circuit 506 may also actuate indicators embedded in the buttons 116 (identified as "menu1 ", "menu2" and "menu3" in FIG. 5). The indicator 112 for the "mains" indication may be driven directly by a mains indicator line 520 and the indicator 112 for "data" indication may be driven directly by a data indicator line 522 when data is communicated via the packet switched network 220 (FIG. 4). Similarly, the indicator 112 for indicating a "fault" in the audio amplifier may be driven by a fault indication line 524.

The example ambient temperature circuit 508 includes a temperature sensor 530 and an amplifier 532 for measuring and providing an ambient temperature signal to the user interface controller 402. The ambient temperature may therefore be used by the user interface controller 402 to determine when an overheating incident is occurring and direct protective action. The audio scaling circuit 510 may receive the audio signals that have been rectified on a rectified input line 534. A scaled output audio signal may be provided on a scaled audio output line 536. For example, the rectified audio input signal may be 13.5 volts and the scaled output audio signal may be 5 volts.

The low voltage regulator circuit 512 may linearly convert DC power supplied by the power supply 206 (FIG. 2), such as 5 volts and -20 volts DC to 3.3 volts and 5 volts DC, respectively. The power switch circuit 514 may provide capability to control on/off power to the audio amplifier 100. In addition, the power switch circuit 514 may provide a power indication 538 when the power is on. Actuation of the power switch circuit 514 illuminates a power LED 538 unless the user interface controller 402 overrides the power switch circuit 514 using a power LED flash control signal provided on a flash control line 539. For example, the user interface controller 402 may flash the power LED 538 when there is a problem with the power supplied to the audio amplifier 100.

The data port 516 may be a communication port for direct communication with the user interface controller 402. For example, the data port 516 may be a twelve pin connector capable of coupling to a lap top computer for purposes of programming the user interface controller 402. The illustrated rotary encoders 114 include three outputs: an up output 540 indicative of clockwise rotation, a down output 542 indicative of counter clockwise rotation and a switch output 544 indicative of when the top of one of the rotary encoders 114 is pushed in. The outputs of each of the rotary encoders 114 are provided to the user interface controller 402. The buttons 116 may be any form of contact closure provided to the user interface controller 402.

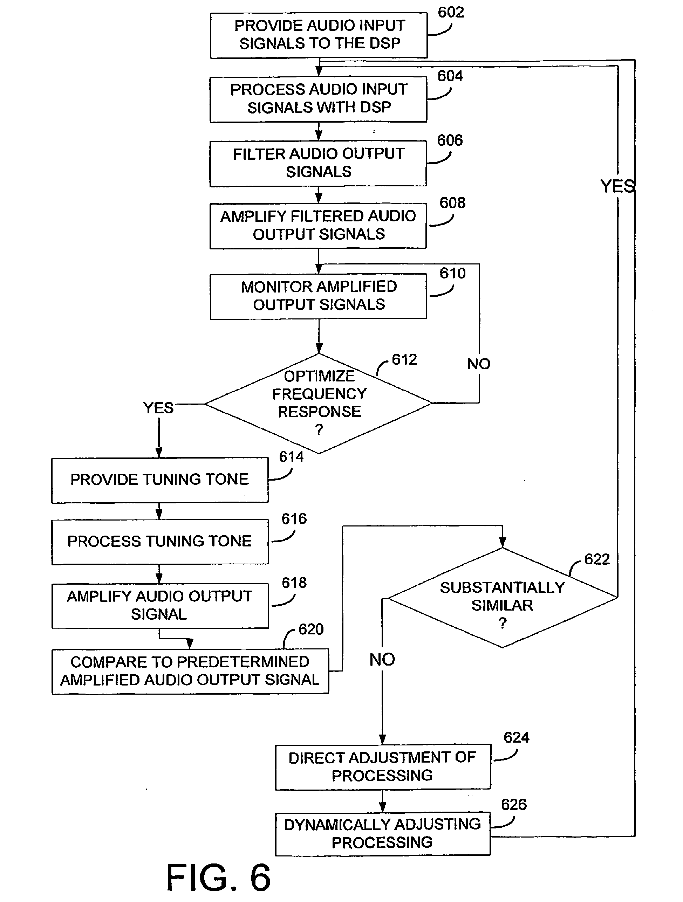

FIG. 6 is an example flow diagram illustrating cooperative operation of the audio signal controller 418 and the DSP 416 described with reference to FIG. 4. The operation begins at block 602 when audio input signals 216 are provided to the DSP 416. At block 604, the audio input signals are processed by the DSP 416 and provided as audio output signals 218. The audio output signals 218 are filtered by the balanced reconstruction filter 210 at block 606. At block 608, the filtered audio output signals 218 are amplified by the power stage 208.

The amplified audio output signals 224 are monitored by the audio signal controller 418 at block 610. At block 612 it is determined by the audio signal controller 418 if the frequency response of the power stage 208 should be optimized. As previously discussed, optimization of the frequency response may be based on calibration, load characteristics or any other frequency related considerations.

If the audio signal controller 418 determines that no frequency optimization is required, the operation returns to block 610 and continues monitoring. If it is determined that frequency optimization is required, the audio signal controller 418 provides a tuning tone as an audio input signal to the DSP 416 at block 614. As previously discussed, the tuning tone may be provided during startup or during operation. If the tuning tone is mixed with other audio input signals during operation, the tuning tone may be a high frequency tone to avoid detection by a listener. If the tuning tone is provided during startup or other diagnostic mode, the tuning tone may be an audible or an inaudible tone. At block 616, the tuning tone is processed by the DSP 416. The resulting audio output signal is amplified by the output stage 208 at block 618. At block 620, the audio signal controller 418 compares the resulting amplified audio output signal to a predetermined amplified audio output signal.

It is determined if the resulting amplified audio output signal and the predetermined audio output signal are substantially similar at block 622. Substantially similarity may be based on a threshold, a percentage or any other comparison to identify the desired level of likeness. The determination may involve comparison of the response error, or the magnitude of the current and voltage of the signals. If the signals are substantially similar, the operation returns to block 604. If the signals are not substantially similar, the audio signal controller 418 directs the DSP 416 to adjust the frequency related processing at block 624. At block 626, the DSP 416 dynamically adjusts the frequency processing of the audio input signals and the operation returns to block 604.

The previously described audio amplifier 100 provides the capability to access, manipulate and control the audio amplifier both locally and over a packet switched network. Local configuration, access and control may be provided with a local interface system. Remote configuration, access and control may be performed over the packet switched network. The local interface system may also be used to communicate over the packet switched network to access, configure and/or control other devices coupled with the packet switched network. Local or remote access may be provided by the audio processing system. The audio processing system may include an audio signal controller and a DSP cooperatively operating to process audio input signals to form audio output signals.

Processing of the audio input signals by the DSP may be configured and controlled via the audio signal controller. The configuration and operation of the DSP may be manually controlled, and/or may be dynamically controlled using the audio signal controller. The audio output signals may be provided through a balanced reconstruction filter to the power stage. The balanced reconstruction filter may divide and filter the audio output signals thereby reducing the magnitude of voltage and current being filtered. The power stage includes a switching amplifier output stage to amplify the audio output signals. Cooperative tuning using the audio signal controller and the DSP may be performed to minimize response errors in the output stage.

While various embodiments of the invention have been described, it will be apparent to those of ordinary skill in the art that many more embodiments and implementations are possible that are within the scope of the invention.

## Claims

1. An audio amplifier (100) that includes an audio processing system (204) configured to be interfaced to a packet switched network (220), and a power stage (208) configured to be controlled and monitored with the audio processing system to produce a plurality of amplified audio output signals (224), the audio amplifier comprising:
a local interface system (102) that includes a panel mounted display screen (110) and a user input device (114, 116);
**characterized in that**
the audio processing system is coupled with the local interface system to enable the audio amplifier to access and configure other devices coupled to the packet switched network with the local interface system of the audio amplifier, where the other devices are configurable with a command initiated with the display screen and the user input device of the local interface system for transmission over the packet switched network to the other devices.

2. The amplifier of claim 1, where the audio processing system is configurable with one of the local interface system or communication over the packet switched network to process an audio input signal (216) that is provided to the power stage.

3. The amplifier of claims 1 or 2, where the audio processing system comprises an audio signal controller (418), a network interface (436) and a digital signal processor (416), the digital signal processor configured to receive and process audio signals as directed, by the audio signal controller.

4. The amplifier as in any of claims 1 to 3, where the local interface system includes an interface controller (402) operable to communicate over an asynchronous serial link (222) with the audio processing system, the audio processing system also configured to communicate over the packet switched network with .an Ethernet communication protocol.

5. The amplifier as in any of claims 1 to 4, where the audio processing system is configured to monitor a first operational parameter of the amplifier and the local interface system is configured to monitor a second operational parameter of the amplifier.

6. The amplifier of claim 5, where the first and second operational parameters are communicated between the audio processing system and the local interface system over a local communication link (222).

7. The amplifier as in any of claims 1 to 6, where the audio processing system is configured to provide adjustment of the gain applied to an input audio signal based on commands provided by the user interface and the display screen or provided from the packet switched network to the audio processing system.

8. The amplifier as in any of claims 1 to 7, where the power stage comprises a pulse width modulated amplifier output stage.

9. The amplifier as in any of claims 1 to 8, where the power stage comprises an output stage that is an opposed current power converter.

10. The amplifier as in any of claims 1 to 9, where the panel mounted display screen is a multiple line character liquid crystal display and the user interface includes a plurality of rotary encoders (114) and a plurality of soft buttons (116).

11. The amplifier of claim 1 where the power stage includes a switching amplifier output stage configured to produce the plurality of amplified audio signals, the audio processing system further includes an audio signal controller (418) configured to communicate over the packet switched network and a digital signal processor (416) coupled with the power stage and in communication with the audio signal controller, where the digital signal processor is configured to receive and process at least one audio input signal that is provided to the power stage for amplification; and
where a gain of the at least one audio input signal that is inputted into the digital signal processor is adjustable with a gain command initiated locally with the local interface system, the gain further adjustable remotely by a command receivable over the packet switched network.

12. The amplifier of claim 11, where the audio signal controller is also configured to dynamically adjust the processing of the at least one audio signal by the digital signal processor based on operational parameters provided as inputs to each of the digital signal processor and the local interface system.

13. The amplifier of claims 11 or 12, where the audio signal controller is configured to dynamically adjust processing of the at least one audio signal by the digital signal processor based on the output voltage and current of the amplified audio signal.

14. The amplifier as in any of claims 11 to 13, where the audio signal controller is configured to dynamically adjust processing by the digital signal processor to optimize the frequency response of the power stage based on comparison of the amplified audio signal to a predetermined amplified audio signal produced from a predetermined audio input signal provided to the digital signal processor by the audio signal controller.

15. The amplifier as in any of claims 11 to 14, where the local interface system is enabled to communicate commands over the packet switched network coupled to other devices also coupled to the packet switched network using the audio signal controller to access or configure said other devices coupled with the packet switched network.

16. The amplifier as in any of claims 15, where the commands are initiated with the panel mounted display screen and the user input device.

17. The amplifier as in any of claims 11 to 16, where the at least one audio input signal is only one audio input signal and the audio signal controller may selectively configure the digital signal processor to provide the only one audio input signal as a first and a second audio output signal to the power stage.

18. The amplifier as in any of claims 11 to 17, where the at least one audio input signal is only one audio input signal and the audio signal controller may selectively configure the digital signal processor to invert the only one audio input signal and provide the only one audio input signal as a first audio output signal to the power stage and provide the inverted only one audio input signal as a second audio output signal to the power stage.

19. The amplifier as in any of claims 11 to 18, where the local interface system includes a first security access level and a second security access level, the first security access level is configured to allow access to the audio signal controller over the packet switched network when a user is successfully authenticated by the first security access level, and the second security access level is configured to allow access by the audio signal controller to a subset of control and setup variables that are only present when a user is successfully authenticated by the second security access level.

20. The amplifier as in any of claims 11 to 19, where the amplified output signal is in a range of about 1250 watts to about 8000 watts.

21. The amplifier of claim 1 where a power stage (208) includes a switching amplifier output stage, the power stage configured to provide the plurality of amplified audio signals for a load, the audio processing system configured to receive an audio input signal (218) and provide a processed audio input signal to the power stage for amplification, and where the audio processing system is further configured to dynamically adjust the processing of the audio input signal to optimize the frequency response of the power stage as a function of the amplified audio signals, where the display screen is a multiple line character liquid crystal display and the user interface includes a rotary encoder (114) and a plurality of buttons (116), and
the rotary encoder and the buttons each with functionality that is dependent on the contents of the multiple line character liquid crystal display.

22. The amplifier of claim 21, where the local interface system is configured to generate a plurality of screens that each include attributes that are indicative of different functions assigned to each of the buttons.

23. The amplifier of claims 21 or 22, further comprising a housing (104), the power stage, the audio processing system and the local interface system disposed inside the housing, except for the display screen and user interface that are surface mounted in a front panel (106) of the housing to be accessible to a user.

24. The amplifier as in any of claims 21 to 23, where the amplified audio signals are provided as feedback signals to the audio processing system and are communicated to the local interface system over a serial communication link (222) by the audio processing system.

25. The amplifier as in any of claims 21 to 24, where the power stage is configured to be controlled and monitored with the combination of the local interface system and the audio processing system.

26. The amplifier as in any of claims 21 to 25, where the audio processing system is configured to be engaged in serial communication with the local interface system and also configured to be engaged in Ethernet based communication over a packet switched network (220).

27. The amplifier as in any of claims 21 to 26, where the audio processing system is configured to monitor the amplified audio signals when a predetermined test signal generated by the audio processing system is amplified by the power stage, the output signal to be compared by the audio processing system with a predetermined output signal, and the audio processing system configured to dynamically optimize the frequency response by making frequency based adjustments to the processed audio input signal to correct for response errors.

28. The amplifier of claim 27, where the audio processing system is configured to make frequency based adjustments by filtering the processed audio input signal to adjust the magnitude of the processed audio input signal.

29. The amplifier as in any of claims 21 to 28, where the audio processing system comprises an audio signal processor (418), a digital signal processor (416) and a digital to analog converter (424), where the audio signal processor is configured to adjust the processing of the digital signal processor, and the audio input signals are processed through the digital signal processor and the digital to analog converter prior to being received at the power stage.

30. The amplifier of claim 29, further comprising a balanced data reconstruction filter (210) coupled with the digital to analog converter, where the digital to analog converter is configured to provide a balanced audio output signal (218) to the balanced reconstruction filter.

31. The amplifier of claim 30, where the balanced reconstruction filter includes a first subfilter (302) configured to filter a positive channel of the balanced audio output signal and a second subfilter (304) configured to filter a negative channel of the balanced audio output signal.

32. The amplifier of claim 30, where the balanced reconstruction filter is configured so that the magnitude of voltage and current of the balanced audio output signal is divided between a first subfilter (302) and a second subfilter (304) included in the balanced reconstruction filter.

33. The amplifier as in any of claims 21 to 32, where the audio processing system is configured to place the amplifier in a standby mode to suspend switching of the switching amplifier output stage based on a standby command received from one of the user interface and the packet switched network.

34. The amplifier as in any of claims 21 to 33, where the audio processing system is configured to communicate over a packet switched network using a transmission control protocol.

35. A method of amplifying audio signals with an amplifier (100) for an audio system that includes an audio processing system (204) configured to be interfaced to a packet switched network (220), wherein a power stage (208) is configured to be controlled and monitored by the audio processing system to produce a plurality of amplified audio output signals (224); wherein the amplifier comprises a local interface system (102) that includes a panel mounted display screen (110) and a user input device (114, 116) the method **characterized by**:
enabling the audio amplifier to access and configure other devices coupled to the packet switched network with the local interface system of the audio amplifier, where the other devices are configurable with a command initiated with the display screen and the user input device of the local interface system for transmission over the packet switched network to the other devices.

36. The method of claim 35, further including the steps of:
optimizing the frequency response of the audio amplifier that includes amplifying audio signals with the power stage having a switching amplifier output stage switch and an output filter (210), where the output filter has a frequency dependent output impedance;
generating with a digital signal processor (416) a predetermined tuning tone as an audio input signal;
processing the predetermined tuning tone with the digital signal processor to generate an amplified audio output signal (224);
an audio signal controller (418) comparing the amplified audio output signal with a predetermined amplified audio output signal; and
the audio signal controller directing dynamic adjustment of the processing by the digital signal processor to optimize the frequency response of the power stage.

37. The method of claim 36, where directing dynamic adjustment of the processing comprises the digital signal processor making frequency dependent magnitude adjustments to the audio input signal being processed by the digital signal processor.

38. The method of claims 36 or 37, where directing dynamic adjustment of the processing comprises automatically making changes to the filtering in the digital signal processor with the audio signal controller.

39. The method as in any of claims 36 to 38, where comparing the amplified audio output signal comprises comparing the current and voltage magnitude of the amplified audio output signal to a predetermined current and voltage magnitude.

40. The method as in any of claims 36 to 39, where comparing the amplified audio output signal comprises identifying response errors between the amplified audio output signal and the predetermined amplified audio output signal.

41. The method as in any of claims 36 to 40, where directing dynamic adjustment of the processing comprises optimizing the frequency response of the power stage to be substantially flat.

42. The method as in any of claims 36 to 41, where generating with a digital signal processor a predetermined tuning tone, comprises initiating generation of the tuning tone automatically upon startup or manually in response to a command.

## Patentansprüche

1. Ein Audioverstärker (100), der ein Audioverarbeitungssystem (204) enthält, das konfiguriert ist, an ein paketvermittelndes Netzwerk (220) angeschlossen zu werden, und eine Leistungsstufe (208) enthält, die konfiguriert ist, mit dem Audioverarbeitungssystem kontrolliert und überwacht zu werden, um eine Vielzahl von verstärkten Audioausgangssignalen (224) zu erzeugen, wobei der Audioverstärker umfasst:
ein lokales Interface-System (102), das einen auf einem Paneel angebrachten Bildschirm (110) und ein Benutzereingabegerät (114, 116) enthält;
**dadurch gekennzeichnet, dass**
das Audioverarbeitungssystem mit dem lokalen Interface-System gekoppelt ist, um dem Audioverstärker zu erlauben, auf andere Geräte, die mit dem paketvermittelnden Netzwerk durch das lokale Interface-System des Audioverstärkers gekoppelt sind, zuzugreifen und zu konfigurieren, wobei die anderen Geräte mit einem Befehl konfigurierbar sind, der durch den Bildschirm und das Benutzereingabegerät des lokalen Interface-Systems veranlasst wurde zur Übertragung über das paketvermittelnde Netzwerk an die anderen Geräte.

2. Der Verstärker aus Anspruch 1, wobei das Audioverarbeitungssystem konfigurierbar ist mit entweder dem lokalen Interface-System oder mittels einer Kommunikation über das paketvermittelnde Netzwerk, ein Audioeingabesignal (216) zu verarbeiten, das an die Leistungsstufe geliefert wird.

3. Der Verstärker aus den Ansprüchen 1 oder 2, wobei das Audioverarbeitungssystem eine Audiosignalsteuerung (418), ein Netzwerk-Interface (436) und einen digitalen Signalprozessor (416) umfasst, wobei der digitale Signalprozessor konfiguriert ist, Audiosignale, wie durch die Audiosignalsteuerung angewiesen, zu empfangen und zu verarbeiten.

4. Der Verstärker gemäß einem der Ansprüche 1 bis 3, wobei das lokale Interface-System eine Interface-Steuerung (402) enthält, die bedienbar ist, um über eine asynchrone serielle Verbindung (222) mit dem Audioverarbeitungssystem zu kommunizieren, wobei das Audioverarbeitungssystem ebenfalls konfiguriert ist, über das paketvermittelnde Netzwerk mittels eines Ethernet-Kommunikationsprotokolls zu kommunizieren.

5. Der Verstärker gemäß einem der Ansprüche 1 bis 4, wobei das Audioverarbeitungssystem konfiguriert ist einen ersten betriebsbedingten Parameter des Verstärkers zu überwachen, und das lokale Interface-System konfiguriert ist, einen zweiten betriebsbedingten Parameter des Verstärkers zu überwachen.

6. Der Verstärker aus Anspruch 5, wobei der erste und zweite betriebsbedingte Parameter zwischen dem Audioverarbeitungssystem und dem lokalen Interface-System über eine lokale Kommunikationsverbindung (222) übertragen werden.

7. Der Verstärker gemäß einem der Ansprüche 1 bis 6, wobei das Audioverarbeitungssystem konfiguriert ist, eine Anpassung einer Verstärkung, die auf ein Eingangsaudiosignal angewendet wird, durchzuführen, basierend auf Befehlen, die durch das Benutzer-Interface und den Bildschirm bereitgestellt werden oder die von dem paketvermittelnden Netzwerk an das Audioverarbeitungssystem bereitgestellt werden.

8. Der Verstärker gemäß einem der Ansprüche 1 bis 7, wobei die Leistungsstufe eine Pulsweitenmodulierungsverstärkerausgangsstufe umfasst.

9. Der Verstärker gemäß einem der Ansprüche 1 bis 8, wobei die Leistungsstufe eine Ausgangsstufe umfasst, die ein entgegengesetzter Stromleistungswandler ist.

10. Der Verstärker gemäß einem der Ansprüche 1 bis 9, wobei der auf einem Paneel angebrachte Bildschirm ein Mehrzeilenzeichenflüssigkristallbildschirm ist, und das Benutzer-Interface eine Vielzahl von Drehgebern (114) und eine Vielzahl von Softknöpfen (116) enthält.

11. Der Verstärker aus Anspruch 1, wobei die Leistungsstufe eine Schaltverstärkerausgangsstufe enthält, die konfiguriert ist, die Vielzahl von verstärkten Audiosignalen zu erzeugen, wobei das Audioverarbeitungssystem des Weiteren eine Audiosignalsteuerung (418) enthält, die konfiguriert ist, über das paketvermittelnde Netzwerk zu kommunizieren, und einen digitalen Signalprozessor (416) enthält, der mit der Leistungsstufe gekoppelt ist und mit der Audiosignalsteuerung kommuniziert, wobei der digitale Signalprozessor konfiguriert ist, wenigstens ein Audioeingabesignal zu empfangen und zu verarbeiten, das an die Leistungsstufe zur Verstärkung bereitgestellt wird; und
wobei eine Verstärkung des wenigstens einen Audioeingabesignals, das an den digitalen Signalprozessor eingegeben wird, durch einen Verstärkungsbefehl anpassbar ist, der lokal durch das lokale Interface-System veranlasst wird, wobei die Verstärkung des Weiteren ferngesteuert anpassbar ist mittels eines Befehls, der über das paketvermittelnde Netzwerk empfangen werden kann.

12. Der Verstärker aus Anspruch 11, wobei die Audiosignalsteuerung ebenfalls konfiguriert ist, die Verarbeitung des wenigstens einen Audiosignals durch den digitalen Signalprozessor dynamisch anzupassen, basierend auf betriebsbedingten Parametern, die als Eingaben an jeweils den digitalen Signalprozessor und das lokale Interface-System bereitgestellt werden.

13. Der Verstärker aus den Ansprüchen 11 oder 12, wobei die Audiosignalsteuerung konfiguriert ist, die Verarbeitung des wenigstens einen Audiosignals durch den digitalen Signalprozessor dynamisch anzupassen, basierend auf der Ausgangsspannung und -strom des verstärkten Audiosignals.

14. Der Verstärker gemäß einem der Ansprüche 11 bis 13, wobei die Audiosignalsteuerung konfiguriert ist, die Verarbeitung durch den digitalen Signalprozessor dynamisch anzupassen, um die Frequenzantwort der Leistungsstufe zu optimieren, basierend auf einem Vergleich des verstärkten Audiosignals mit einem vorher bestimmten verstärkten Audiosignal, das aus einem vorher bestimmten Audioeingabesignal erzeugt wird, das durch die Audiosignalsteuerung an den digitalen Signalprozessor bereitgestellt wird.

15. Der Verstärker gemäß einem der Ansprüche 11 bis 14, wobei das lokale Interface-System angepasst ist, Befehle über das paketvermittelnde Netzwerk zu übertragen, das mit anderen Geräten gekoppelt ist, die ebenfalls mit dem paketvermittelnden Netzwerk gekoppelt sind, unter Verwendung der Audiosignalsteuerung, um auf diese anderen Geräte, die mit dem paketvermittelnden Netzwerk gekoppelt sind, zuzugreifen oder zu konfigurieren.

16. Der Verstärker gemäß einem der Ansprüche 15, wobei die Befehle durch den auf einem Paneel angebrachten Bildschirm und das Benutzereingangsgerät veranlasst werden.

17. Der Verstärker gemäß einem der Ansprüche 11 bis 16, wobei das wenigstens eine Audioeingabesignal nur ein Audioeingabesignal ist, und die Audiosignalsteuerung den digitalen Signalprozessor selektiv konfigurieren kann, das nur eine Audioeingabesignal als ein erstes und ein zweites Audioausgangssignal an die Leistungsstufe bereitzustellen.

18. Der Verstärker gemäß einem der Ansprüche 11 bis 17, wobei das wenigstens eine Audioeingabesignal nur ein Audioeingabesignal ist, und die Audiosignalsteuerung den digitalen Signalprozessor selektiv konfigurieren kann, das nur eine Audioeingabesignal zu invertieren und das nur eine Audioeingabesignal als ein erstes Audioausgabesignal an die Leistungsstufe bereitzustellen und das invertierte nur eine Audioeingabesignal als ein zweites Audioausgabesignal an die Leistungsstufe bereitzustellen.

19. Der Verstärker gemäß einem der Ansprüche 11 bis 18, wobei das lokale Interface-System eine erste Sicherheitszugriffsebene und eine zweite Sicherheitszugriffsebene enthält, wobei die erste Sicherheitszugriffsebene konfiguriert ist, einen Zugriff auf die Audiosignalsteuerung über das paketvermittelnde Netzwerk zu erlauben, wenn ein Benutzer durch die erste Sicherheitszugriffsebene erfolgreich authentifiziert wurde, und wobei die zweite Sicherheitszugriffsebene konfiguriert ist, einen Zugriff durch die Audiosignalsteuerung auf einen Teilsatz der Steuerungs- und Setup-Variablen zu erlauben, die nur dann vorhanden sind, wenn ein Benutzer durch die zweite Sicherheitszugriffsebene erfolgreich authentifiziert wurde.

20. Der Verstärker gemäß einem der Ansprüche 11 bis 19, wobei das verstärkte Ausgangssignal in einen Bereich von etwa 1.250 Watt bis etwa 8.000 Watt liegt.

21. Der Verstärker aus Anspruch 1, wobei eine Leistungsstufe (208) eine Schaltverstärkerausgangsstufe enthält, wobei die Leistungsstufe konfiguriert ist, die Vielzahl von verstärkten Audiosignalen für eine Last bereitzustellen, wobei das Audioverarbeitungssystem konfiguriert ist, ein Audioeingabesignal (218) zu empfangen und ein verarbeitetes Audioeingabesignal an die Leistungsstufe zur Verstärkung bereitzustellen, und wobei das Audioverarbeitungssystem des Weiteren konfiguriert ist, die Verarbeitung des Audioeingabesignals dynamisch anzupassen, um die Frequenzantwort der Leistungsstufe als eine Funktion der verstärkten Audiosignale zu optimieren, wobei der Bildschirm ein Mehrzeilenzeichenflüssigkristallbildschirm ist und das Benutzer-Interface einen Drehgeber (114) und eine Vielzahl von Knöpfen (116) enthält, und
wobei der Drehgeber und die Knöpfe jeweils eine Funktionalität aufweisen, die abhängig von dem Inhalt des Mehrzeilenzeichenflüssigkristallbildschirms ist.

22. Der Verstärker des Anspruchs 21, wobei das lokale Interface-System konfiguriert ist eine Vielzahl von Bildschirmen zu erzeugen, die jeweils Attribute enthalten, die bezeichnend sind für die unterschiedlichen Funktionen, die jedem der Knöpfe zugewiesen werden.

23. Der Verstärker der Ansprüche 21 oder 22, weiterhin umfassend ein Gehäuse (104), wobei die Leistungsstufe, das Audioverarbeitungssystem und das lokale Interface-System innerhalb des Gehäuses untergebracht sind, mit Ausnahme des Bildschirms und des Benutzer-Interfaces, die in einem Frontpaneel (106) des Gehäuses oberflächenmontiert sind, um für einen Benutzer zugänglich zu sein.

24. Der Verstärker gemäß einem der Ansprüche 21 bis 23, wobei die verstärkten Audiosignale als Feedback-Signale an das Audioverarbeitungssystem bereitgestellt werden und an das lokale Interface-System über eine serielle Kommunikationsverbindung (222) durch das Audioverarbeitungssystem übertragen werden.

25. Der Verstärker gemäß einem der Ansprüche 21 bis 24, wobei die Leistungsstufe konfiguriert ist, durch eine Zusammenarbeit des lokalen Interface-Systems und des Audioverarbeitungssystems kontrolliert und überwacht zu werden.

26. Der Verstärker gemäß einem der Ansprüche 21 bis 25, wobei das Audioverarbeitungssystem konfiguriert ist, sich an einer seriellen Kommunikation mit dem lokalen Interface-System zu beteiligen und ebenfalls konfiguriert ist, sich an einer Ethernet-basierten Kommunikation über ein paketvermittelndes Netzwerk (220) zu beteiligen.

27. Der Verstärker gemäß einem der Ansprüche 21 bis 26, wobei das Audioverarbeitungssystem konfiguriert ist, die verstärkten Audiosignale zu überwachen, wenn ein vorher bestimmtes Testsignal, das durch das Audioverarbeitungssystem erzeugt wird, durch die Leistungsstufe verstärkt wird, wobei das Ausgangssignal durch das Audioverarbeitungssystem mit einem vorher bestimmten Ausgangssignal verglichen wird, und wobei das Audioverarbeitungssystem konfiguriert ist, die Frequenzantwort dynamisch zu optimieren, indem frequenzbasierte Anpassungen an das verarbeitete Audioeingabesignal vorzugenommen werden, um Antwortfehler zu korrigieren.

28. Der Verstärker aus Anspruch 27, wobei das Audioverarbeitungssystem konfiguriert ist frequenzbasierte Anpassungen vorzunehmen, indem das verarbeitete Audioeingabesignal gefiltert wird, um die Stärke des verarbeiteten Audioeingabesignals anzupassen.

29. Der Verstärker gemäß einem der Ansprüche 21 bis 28, wobei das Audioverarbeitungssystem einen Audiosignalprozessor (418), einen digitalen Signalprozessor (416) und einen Digital- nach Analogkonverter (424) umfasst, wobei der Audiosignalprozessor konfiguriert ist, den Betrieb des digitalen Signalprozessors anzupassen, und wobei die Audioeingabesignale durch den digitalen Signalprozessor und den Digital- nach Analogkonverter verarbeitet werden, bevor diese an der Leistungsstufe empfangen werden.

30. Der Verstärker aus Anspruch 29, weiterhin umfassend einen Datenrekonstruktionsausgleichsfilter (210), der mit dem Digital- nach Analogkonverter gekoppelt ist, wobei der Digital- nach Analogkonverter konfiguriert ist, ein ausgeglichenes Audioausgangssignal (218) an den Rekonstruktionsausgleichsfilter bereitzustellen.

31. Der Verstärker aus Anspruch 30, wobei der Rekonstruktionsausgleichsfilter einen ersten Unterfilter (302) enthält, der konfiguriert ist, einen positiven Kanal des ausgeglichenen Audioausgangssignals zu filtern, und einen zweiten Unterfilter (304) enthält, der konfiguriert ist, einen negativen Kanal des ausgeglichenen Audioausgangssignals zu filtern.

32. Der Verstärker aus Anspruch 30, wobei der Rekonstruktionsausgleichsfilter so konfiguriert ist, dass die Stärke der Spannung und des Stroms des ausgeglichenen Audioausgabesignals geteilt wird zwischen einem ersten Unterfilter (302) und einem zweiten Unterfilter (304), die in dem Rekonstruktionsausgleichsfilter enthalten sind.

33. Der Verstärker gemäß einem der Ansprüche 21 bis 32, wobei das Audioverarbeitungssystem konfiguriert ist, den Verstärker in einen Stand-by-Modus zu bringen, um das Schalten der Schaltverstärkerausgangsstufe auszusetzen, basierend auf einem Stand-by-Befehl, der von entweder dem Benutzer-Interface oder dem paketvermiftelnden Netzwerk empfangen wird.

34. Der Verstärker gemäß einem der Ansprüche 21 bis 33, wobei das Audioverarbeitungssystem konfiguriert ist, über ein paketvermittelndes Netzwerk unter Verwendung eines Übertragungssteuerungsprotokolls zu kommunizieren.

35. Ein Verfahren zum Verstärken von Audiosignalen mit einem Verstärker (100) für ein Audiosystem, das ein Audioverarbeitungssystem (204) enthält, das konfiguriert ist, an ein paketvermittelndes Netzwerk (220) angeschlossen zu werden, wobei eine Leistungsstufe (208) konfiguriert ist, durch das Audioverarbeitungssystem gesteuert und überwacht zu werden, um eine Vielzahl von verstärkten Audioausgangssignalen (224) zu erzeugen;
wobei der Verstärker ein lokales Interface-System (102) umfasst, das einen auf einem Paneel angebrachten Bildschirm (110) und ein Benutzereingabegerät (114, 116) enthält,
wobei das Verfahren **dadurch gekennzeichnet ist, dass**
dem Audioverstärker erlaubt wird, auf andere Geräte zuzugreifen und zu konfigurieren, die mit dem paketvermittelnden Netzwerk durch das lokale Interface-System des Audioverstärkers gekoppelt sind, wobei die anderen Geräte mit einem Befehl konfigurierbar sind, der durch den Bildschirm und das Benutzereingabegerät des lokalen Interface-Systems veranlasst wurde zur Übertragung über das paketvermittelnde Netzwerk an die anderen Geräte.

36. Das Verfahren aus Anspruch 35, des Weiteren die Schritte umfassend von:
Optimieren der Frequenzantwort des Audioverstärkers inklusive dem Verstärken von Audiosignalen durch die Leistungsstufe, die einen Schaltverstärkerausgangsstufenschalter und einen Ausgangsfilter (210) aufweist, wobei der Ausgangsfilter eine frequenzabhängige Ausgangsimpedanz aufweist;
durch einen digitalen Signalprozessor (416) ausgeführtes Erzeugen eines vorher bestimmten Abstimmlautes als Audioeingabesignal;
durch den digitalen Signalprozessor ausgeführtes Verarbeiten des vorher bestimmten Abstimmlautes, um ein verstärktes Audioausgabesignal (224) zu erzeugen;
durch eine Audiosignalsteuerung (418) ausgeführtes Vergleichen des verstärkten Audioausgangssignals mit einem vorher bestimmten verstärkten Audioausgangssignal; und
durch die Audiosignalsteuerung ausgeführtes Steuern der dynamischen Anpassung der Verarbeitung durch den digitalen Signalprozessor zum Optimieren der Frequenzantwort der Leistungsstufe.

37. Das Verfahren des Anspruchs 36, wobei das Steuern der dynamischen Anpassung der Verarbeitung umfasst, dass der digitale Signalprozessor frequenzabhängige Stärkeanpassungen bei dem Audioeingabesignal durchführt, das durch den digitalen Signalprozessor verarbeitet wird.

38. Das Verfahren der Ansprüche 36 oder 37, wobei das Steuern der dynamischen Anpassung der Verarbeitung umfasst, dass Änderungen bei dem Filtern in dem digitalen Signalprozessor durch die Audiosignalsteuerung automatisch durchgeführt werden.

39. Das Verfahren gemäß einem der Ansprüche 36 bis 38, wobei das Vergleichen des verstärkten Audioausgabesignals umfasst, dass die Strom- und Spannungsstärke des verstärkten Audioausgabesignals mit einer vorher bestimmten Strom- und Spannungsstärke verglichen wird.

40. Das Verfahren gemäß einem der Ansprüche 36 bis 39, wobei das Vergleichen des verstärkten Audioausgabesignals umfasst, dass Antwortfehler zwischen dem verstärkten Audioausgabesignal und dem vorher bestimmten verstärkten Audioausgabesignal identifiziert werden.

41. Das Verfahren gemäß einem der Ansprüche 36 bis 40, wobei das Steuern der dynamischen Anpassung der Verarbeitung umfasst, dass die Frequenzantwort der Leistungsstufe so optimiert wird, dass diese im Wesentlichen flach ist.

42. Das Verfahren gemäß einem der Ansprüche 36 bis 41, wobei die Erzeugung eines vorher bestimmten Abstimmlautes durch einen digitalen Signalprozessor umfasst, dass die Erzeugung des Abstimmlautes auf automatische Weise bei Inbetriebnahme oder manuell in Antwort auf einen Befehl veranlasst wird.

## Revendications

1. Amplificateur audio (100) comprenant un système de traitement audio (204) configuré pour être interfacé avec un réseau à commutation de paquets (220), et un étage de puissance (208) configuré pour être commandé et surveillé par le système de traitement audio pour produire une pluralité de signaux de sortie audio amplifiés (224), l'amplificateur audio comprenant :
- un système d'interface locale (102) qui comprend un écran d'affichage monté sur panneau (110) et un dispositif d'entrée d'utilisateur (114, 116) ;
- **caractérisé en ce que**
- le système de traitement audio est couplé au système d'interface locale pour permettre à l'amplificateur audio d'accéder et de configurer d'autres dispositifs couplés au réseau à commutation de paquets avec le système d'interface locale de l'amplificateur audio, dans lequel les autres dispositifs sont configurables par une commande lancée à partir de l'écran d'affichage et du dispositif d'entrée d'utilisateur du système d'interface locale pour une transmission via le réseau à commutation de paquets vers les autres dispositifs.

2. Amplificateur selon la revendication 1, dans lequel le système de traitement audio est configurable soit par le système d'interface locale, soit par une communication via le réseau à commutation de paquets, pour traiter un signal d'entrée audio (216) fourni à l'étage de puissance.

3. Amplificateur selon la revendication 1 ou 2, dans lequel le système de traitement audio comprend un contrôleur de signaux audio (418), une interface réseau (436) et un processeur de signaux numériques (416), le processeur de signaux numériques étant configuré pour recevoir et traiter des signaux audio selon les instructions du contrôleur de signaux audio.

4. Amplificateur selon l'une quelconque des revendications 1 à 3, dans lequel le système d'interface locale comprend un contrôleur d'interface (402) utilisable pour communiquer via une liaison série asynchrone (222) avec le système de traitement audio, le système de traitement audio étant également configuré pour communiquer via le réseau à commutation de paquets avec un protocole de communication Ethernet.

5. Amplificateur selon l'une quelconque des revendications 1 à 4, dans lequel le système de traitement audio est configuré pour surveiller un premier paramètre opérationnel de l'amplificateur et le système d'interface locale est configuré pour surveiller un deuxième paramètre opérationnel de l'amplificateur.

6. Amplificateur selon la revendication 5, dans lequel les premier et deuxième paramètres opérationnels sont communiqués entre le système de traitement audio et le système d'interface locale via une liaison de communication locale (222).

7. Amplificateur selon l'une quelconque des revendications 1 à 6, dans lequel le système de traitement audio est configuré pour procurer un ajustement du gain appliqué à un signal audio d'entrée en fonction de commandes fournies par l'interface d'utilisateur et par l'écran d'affichage ou fournies par le réseau à commutation de paquets au système de traitement audio.

8. Amplificateur selon l'une quelconque des revendications 1 à 7, dans lequel l'étage de puissance comprend un étage de sortie d'amplificateur à modulation de largeur d'impulsion.

9. Amplificateur selon l'une quelconque des revendications 1 à 8, dans lequel l'étage de puissance comprend un étage de sortie qui est un convertisseur de puissance à courants opposés.

10. Amplificateur selon l'une quelconque des revendications 1 à 9, dans lequel l'écran d'affichage monté sur panneau est un afficheur à cristaux liquides à multiples lignes de caractères et l'interface d'utilisateur comprend une pluralité de codeurs rotatifs (114) et une pluralité de boutons programmables (116).

11. Amplificateur selon la revendication 1, dans lequel l'étage de puissance comprend un étage de sortie d'amplificateur à découpage configuré pour produire la pluralité de signaux audio amplifiés, le système de traitement audio comprend en outre un contrôleur de signaux audio (418) configuré pour communiquer via le réseau à commutation de paquets et un processeur de signaux numériques (416) couplé à l'étage de puissance et en communication avec le contrôleur de signaux audio, dans lequel le processeur de signaux numériques est configuré pour recevoir et traiter au moins un signal d'entrée audio qui est fourni à l'étage de puissance pour son amplification ; et
- dans lequel un gain de l'au moins un signal d'entrée audio qui est fourni en entrée au processeur de signaux numériques est réglable par une commande de gain lancée localement au système d'interface locale, le gain étant en outre réglable à distance par une commande recevable via le réseau à commutation de paquets.

12. Amplificateur selon la revendication 11, dans lequel le contrôleur de signaux audio est également configuré pour ajuster dynamiquement le traitement de l'au moins un signal audio par le processeur de signaux numériques en fonction de paramètres opérationnels fournis en entrée au processeur de signaux numériques et au système d'interface locale.

13. Amplificateur selon la revendication 11 ou 12, dans lequel le contrôleur de signaux audio est configuré pour ajuster dynamiquement le traitement de l'au moins un signal audio par le processeur de signaux numériques en fonction de la tension et du courant de sortie du signal audio amplifié.

14. Amplificateur selon l'une quelconque des revendications 11 à 13, dans lequel le contrôleur de signaux audio est configuré pour ajuster dynamiquement le traitement par le processeur de signaux numériques afin d'optimiser la réponse en fréquence de l'étage de puissance en fonction d'une comparaison entre le signal audio amplifié et un signal audio amplifié prédéterminé produit à partir d'un signal d'entrée audio prédéterminé fourni au processeur de signaux numériques par le contrôleur de signaux audio.

15. Amplificateur selon l'une quelconque des revendications 11 à 14, dans lequel le système d'interface locale est autorisé à communiquer des commandes via le réseau à commutation de paquets couplé à d'autres dispositifs également couplés au réseau à commutation de paquets en utilisant le contrôleur de signaux audio pour accéder ou configurer lesdits autres dispositifs couplés au réseau à commutation de paquets.

16. Amplificateur selon l'une quelconque des revendications 11 à 15, dans lequel les commandes sont lancées à partir de l'écran d'affichage monté et du dispositif d'entrée d'utilisateur.

17. Amplificateur selon l'une quelconque des revendications 11 à 16, dans lequel l'au moins un signal d'entrée audio est un signal d'entrée audio unique et le contrôleur de signaux audio peut configurer sélectivement le processeur de signaux numériques pour fournir le signal d'entrée audio unique en tant que premier et deuxième signaux de sortie audio à l'étage de puissance.

18. Amplificateur selon l'une quelconque des revendications 11 à 17, dans lequel l'au moins un signal d'entrée audio est un signal d'entrée audio unique et le contrôleur de signaux audio peut configurer sélectivement le processeur de signaux numériques pour inverser le signal d'entrée audio unique et fournir le signal d'entrée audio unique en tant que premier signal de sortie audio à l'étage de puissance et fournir le signal d'entrée audio unique inversé en tant que deuxième signal de sortie audio à l'étage de puissance.

19. Amplificateur selon l'une quelconque des revendications 11 à 18, dans lequel le système d'interface locale comprend un premier niveau d'accès de sécurité et un deuxième niveau d'accès de sécurité, le premier niveau d'accès de sécurité est configuré pour permettre l'accès au contrôleur de signaux audio via le réseau à commutation de paquets lorsqu'un utilisateur est authentifié avec succès par le premier niveau d'accès de sécurité, et le deuxième niveau d'accès de sécurité est configuré pour permettre l'accès par le contrôleur de signaux audio à un sous-ensemble de variables de commande et de configuration qui ne sont présentes que lorsqu'un utilisateur est authentifié avec succès par le deuxième niveau d'accès de sécurité.

20. Amplificateur selon l'une quelconque des revendications 11 à 19, dans lequel le signal de sortie amplifié a une puissance comprise dans une plage d'environ 1 250 watts à environ 8 000 watts.

21. Amplificateur selon la revendication 1, dans lequel un étage de puissance (208) comprend un étage de sortie d'amplificateur à découpage, l'étage de puissance est configuré pour fournir la pluralité de signaux audio amplifiés à une charge, le système de traitement audio est configuré pour recevoir un signal d'entrée audio (218) et fournir un signal d'entrée audio traité à l'étage de puissance pour son amplification, et dans lequel le système de traitement audio est en outre configuré pour ajuster dynamiquement le traitement du signal d'entrée audio pour optimiser la réponse en fréquence de l'étage de puissance en fonction des signaux audio amplifiés, dans lequel l'écran d'affichage est un afficheur à cristaux liquides à multiples lignes de caractères et l'interface d'utilisateur comprend un codeur rotatif (114) et une pluralité de boutons (116), et
- le codeur rotatif et les boutons ont chacun une fonctionnalité qui dépend des contenus de l'afficheur à cristaux liquides à multiples lignes de caractères.

22. Amplificateur selon la revendication 21, dans lequel le système d'interface locale est configuré pour générer une pluralité d'écrans qui comprennent chacun des attributs qui sont indicatifs de différentes fonctions assignées à chacun des boutons.

23. Amplificateur selon la revendication 21 ou 22, comprenant en outre un boîtier (104), l'étage de puissance, le système de traitement audio et le système d'interface locale étant disposés à l'intérieur du boîtier, excepté l'écran d'affichage et l'interface d'utilisateur qui sont montés en surface dans un panneau frontal (106) du boîtier afin d'être accessibles pour un utilisateur.

24. Amplificateur selon l'une quelconque des revendications 21 à 23, dans lequel les signaux audio amplifiés sont fournis en tant que signaux de rétroaction au système de traitement audio et sont communiqués au système d'interface locale via une liaison de communication série (222) par le système de traitement audio.

25. Amplificateur selon l'une quelconque des revendications 21 à 24, dans lequel l'étage de puissance est configuré pour être commandé et surveillé par la combinaison du système d'interface locale et du système de traitement audio.

26. Amplificateur selon l'une quelconque des revendications 21 à 25, dans lequel le système de traitement audio est configuré pour être engagé dans une communication série avec le système d'interface locale et est également configuré pour être engagé dans une communication fondée sur l'Ethernet via un réseau à commutation de paquets (220).

27. Amplificateur selon l'une quelconque des revendications 21 à 26, dans lequel le système de traitement audio est configuré pour surveiller les signaux audio amplifiés lorsqu'un signal d'essai prédéterminé généré par le système de traitement audio est amplifié par l'étage de puissance, le signal de sortie devant être comparé par le système de traitement audio à un signal de sortie prédéterminé, et le système de traitement audio étant configuré pour optimiser dynamiquement la réponse en fréquence en effectuant des ajustements, en fonction de la fréquence, du signal d'entrée audio traité pour corriger des erreurs de réponse.

28. Amplificateur selon la revendication 27, dans lequel le système de traitement audio est configuré pour effectuer des ajustements en fonction de la fréquence en filtrant le signal d'entrée audio traité pour ajuster l'amplitude du signal d'entrée audio traité.

29. Amplificateur selon l'une quelconque des revendications 21 à 28, dans lequel le système de traitement audio comprend un processeur de signaux audio (418), un processeur de signaux numériques (416) et un convertisseur numérique/analogique (424), dans lequel le processeur de signaux audio est configuré pour ajuster le traitement du processeur de signaux numériques, et les signaux d'entrée audio sont traités par le processeur de signaux numériques et le convertisseur numérique/analogique avant d'être reçus par l'étage de puissance.

30. Amplificateur selon la revendication 29, comprenant en outre un filtre de reconstitution de données symétrique (210) couplé au convertisseur numérique/analogique, dans lequel le convertisseur numérique/analogique est configuré pour fournir un signal de sortie audio symétrique (218) au filtre de reconstitution symétrique.

31. Amplificateur selon la revendication 30, dans lequel le filtre de reconstitution symétrique comprend un premier sous-filtre (302) configuré pour filtrer un canal positif du signal de sortie audio symétrique et un deuxième sous-filtre (304) configuré pour filtrer un canal négatif du signal de sortie audio symétrique.

32. Amplificateur selon la revendication 30, dans lequel le filtre de reconstitution symétrique est configuré de telle manière que l'amplitude de la tension et du courant du signal de sortie audio symétrique soit divisée entre un premier sous-filtre (302) et un deuxième sous-filtre (304) inclus dans le filtre de reconstitution symétrique.

33. Amplificateur selon l'une quelconque des revendications 21 à 32, dans lequel le système de traitement audio est configuré pour placer l'amplificateur en mode d'attente pour suspendre le découpage de l'étage de sortie d'amplificateur à découpage en fonction d'une commande d'attente reçue soit de l'interface d'utilisateur, soit du réseau à commutation de paquets.

34. Amplificateur selon l'une quelconque des revendications 21 à 33, dans lequel le système de traitement audio est configuré pour communiquer via un réseau à commutation de paquets en utilisant un protocole de commande de transmission.

35. Procédé d'amplification de signaux audio avec un amplificateur (100) pour un système audio comprenant un système de traitement audio (204) configuré pour être interfacé avec un réseau à commutation de paquets (220), dans lequel un étage de puissance (208) est configuré pour être commandé et surveillé par le système de traitement audio afin de produire une pluralité de signaux de sortie audio amplifiés (224) ; dans lequel l'amplificateur comprend un système d'interface locale (102) qui comprend un écran d'affichage monté sur panneau (110) et un dispositif d'entrée d'utilisateur (114, 116), le procédé étant **caractérisé par** :
- l'autorisation de l'amplificateur audio à accéder à et à configurer d'autres dispositifs couplés au réseau à commutation de paquets avec le système d'interface locale de l'amplificateur audio, dans lequel les autres dispositifs sont configurables par une commande lancée à partir de l'écran d'affichage et du dispositif d'entrée d'utilisateur du système d'interface locale pour une transmission via le réseau à commutation de paquets vers les autres dispositifs.

36. Procédé selon la revendication 35, comprenant en outre les étapes consistant à :
- optimiser la réponse en fréquence de l'amplificateur audio, ce qui comprend une amplification de signaux audio par l'étage de puissance comportant un dispositif de commutation d'étage de sortie d'amplificateur à découpage et un filtre de sortie (210), dans lequel l'impédance de sortie du filtre de sortie dépend de la fréquence ;
- générer avec un processeur de signaux numériques (416) une tonalité d'étalonnage prédéterminée en tant que signal d'entrée audio;
- traiter la tonalité d'étalonnage prédéterminée avec le processeur de signaux numériques pour générer un signal de sortie audio amplifié (224) ;
- comparer à l'aide d'un contrôleur de signaux audio (418) le signal de sortie audio amplifié à un signal de sortie audio amplifié prédéterminé ; et
- commander par le contrôleur de signaux audio l'ajustement dynamique du traitement par le processeur de signaux numériques pour optimiser la réponse en fréquence de l'étage de puissance.

37. Procédé selon la revendication 36, dans lequel la commande de l'ajustement dynamique du traitement comprend des ajustements, par le processeur de signaux numériques, de l'amplitude, dépendant de la fréquence, du signal d'entrée audio en cours de traitement par le processeur de signaux numériques.

38. Procédé selon la revendication 36 ou 37, dans lequel la commande de l'ajustement dynamique du traitement comprend l'application automatique de changements au filtrage dans le processeur de signaux numériques par le contrôleur de signaux audio.

39. Procédé selon l'une quelconque des revendications 36 à 38, dans lequel la comparaison du signal de sortie audio amplifié comprend la comparaison de l'amplitude du courant et de la tension du signal de sortie audio amplifié à une amplitude de courant et de tension prédéterminée.

40. Procédé selon l'une quelconque des revendications 36 à 39, dans lequel la comparaison du signal de sortie audio amplifié comprend l'identification d'erreurs de réponse entre le signal de sortie audio amplifié et le signal de sortie audio amplifié prédéterminé.

41. Procédé selon l'une quelconque des revendications 36 à 40, dans lequel la commande de l'ajustement dynamique du traitement comprend une optimisation de la réponse en fréquence de l'étage de puissance pour qu'elle soit sensiblement plate.

42. Procédé selon l'une quelconque des revendications 36 à 41, dans lequel la génération d'une tonalité d'étalonnage prédéterminée par un processeur de signaux numériques comprend le lancement automatique de la génération de la tonalité d'étalonnage lors du démarrage ou manuellement en réponse à une commande.
